# EUROPEAN PATENT APPLICATION

(11) **EP 4 668 337 A1**
(43) Date of publication of application: **24.12.2025**
(21) Application number: 25182271.4
(22) Date of filing: 12.06.2025
(51) Int. Cl.: H01L 25/075, H01L 25/16, H10H 20/819, H10H 20/831, H10H 20/833, H10H 20/832, H10H 20/84, H10H 20/841, H10H 29/30, H10H 29/37, H10H 29/80, H10H 29/853

(54) **DISPLAY APPARATUS**

(30) Priority: 18.06.2024 KR 20240078807
(71) Applicant: Samsung Electronics Co., Ltd., Suwon-si, Gyeonggi-do 16677 (KR)
(72) Inventor: JEON, Joonwoo, 16677 Suwon-si, Gyeonggi-do (KR); KIM, Juhyun, 16677 Suwon-si, Gyeonggi-do (KR); SHON, Byungjoo, 16677 Suwon-si, Gyeonggi-do (KR); SHIN, Youngsub, 16677 Suwon-si, Gyeonggi-do (KR); SIM, Jaein, 16677 Suwon-si, Gyeonggi-do (KR); HA, Jonghoon, 16677 Suwon-si, Gyeonggi-do (KR)
(74) Representative: Kuhnen & Wacker Patent- und Rechtsanwaltsbüro PartG mbB

(57) **Abstract**

A display apparatus (10) includes a pixel array (100) which includes a plurality of pixel units (PX), a semiconductor stack (110), a spacer (160), a reflective electrode, and a plurality of connection electrodes (155). The semiconductor stack (110) includes a plurality of light-emitting diode, LED, cells (LC1, LC2, LC3) on a first conductivity-type semiconductor base layer (112b), and a second conductivity-type semiconductor layer (116) stacked on the first conductivity-type semiconductor base layer (112b). The spacer (160) at least partially covers a side surface and a lower surface of each of the plurality of LED cells (LC1, LC2, LC3) and has an inclined sidewall (160S). A reflective electrode (130) is on the inclined sidewall (160S) of the spacer (160) and electrically coupled with the first conductivity-type semiconductor base layer (112b) between the plurality of LED cells (LC1, LC2, LC3). The plurality of connection electrodes (155) is electrically coupled with the second conductivity-type semiconductor layer (116) on the lower surface of each of the plurality of LED cells (LC1, LC2, LC3) through a contact hole.

## Description

### BACKGROUND

### 1. Field

The present disclosure relates generally, to a display apparatus, and more particularly, a display apparatus having a light emitting diode (LED) cell and a method of manufacturing the same.

### 2. Description of Related Art

A semiconductor light emitting diode (LED) may be used as a light source for various electronic products and/or a lighting device. For example, an LED may be used as a light source for various display apparatuses such as, but not limited to, a television (TV), a mobile phone, a personal computer (PC), a laptop computer, a tablet computer, a personal digital assistant (PDA), or the like.

A display apparatus may be and/or may include a display panel configured as a liquid crystal display (LCD) and a backlight. Alternatively or additionally, a display apparatus may include LEDs that may be used as pixels, and as such, a backlight may not be needed. Such a display apparatus may be miniaturized and may implement a high-brightness display apparatus having a light efficiency that may be comparable to a light efficiency of a display apparatus implemented with LCDs.

### SUMMARY

One or more example embodiments of the present disclosure provide a display apparatus having luminous efficiency.

According to an aspect of the present disclosure, a display apparatus includes a pixel array which includes a plurality of pixel units, a semiconductor stack, a spacer, a reflective electrode, and a plurality of connection electrodes. Each of the plurality of pixel units includes a plurality of sub-pixels. The semiconductor stack includes a first conductivity-type semiconductor base layer having an upper surface provided as a light emitting surface, a plurality of light-emitting diode (LED) cells on a lower surface of the first conductivity-type semiconductor base layer, and a second conductivity-type semiconductor layer stacked on the lower surface of the first conductivity-type semiconductor base layer. Each of the plurality of LED cells include at least an active layer. The spacer at least partially covers a side surface and a lower surface of each of the plurality of LED cells and has an inclined sidewall. The spacer includes a contact hole coupled with a second portion of the second conductivity-type semiconductor layer on the lower surface of each of the plurality of LED cells. The reflective electrode is disposed on the inclined sidewall of the spacer and is electrically coupled with a first portion of the first conductivity-type semiconductor base layer between the plurality of LED cells. The plurality of connection electrodes is electrically coupled with the second portion of the second conductivity-type semiconductor layer on the lower surface of each of the plurality of LED cells through the contact hole.

According to an aspect of the present disclosure, a display apparatus includes a pixel array in which a plurality of pixel units are disposed. Each of the plurality of pixel units includes a plurality of sub-pixels. The pixel array includes a semiconductor stack, a spacer, a reflective electrode, and a connection electrode. The semiconductor stack includes a first conductivity-type semiconductor base layer including an upper surface provided as a light emitting surface, a plurality of LED cells on a lower surface of the first conductivity-type semiconductor base layer, and a second conductivity-type semiconductor layer. Each of the plurality of LED cells includes at least an active layer. The spacer at least partially covers a side surface and a lower surface of each of the plurality of LED cells and has an inclined sidewall. The spacer includes a contact hole coupled with a portion of the second conductivity-type semiconductor layer on the lower surface of each of the plurality of LED cells. The reflective electrode is disposed on the inclined sidewall of the spacer and is electrically coupled with the first conductivity-type semiconductor base layer. The connection electrode is electrically coupled with the portion of the second conductivity-type semiconductor layer of each of the plurality of LED cells through the contact hole of the spacer. A region of the first conductivity-type semiconductor base layer between the plurality of LED cells includes first regions on which the spacer is disposed and a recessed second region therebetween. The reflective electrode is electrically coupled with the recessed second region along the inclined sidewall of the spacer.

According to an aspect of the present disclosure, a display apparatus includes a pixel array in which a plurality of pixel units are disposed. Each of the plurality of pixel units includes a plurality of sub-pixels. The pixel array includes a plurality of LED cells, a spacer, a plurality of reflective electrodes, a gap-fill insulating layer, a first electrode, and a plurality of second electrodes. Each of the plurality of LED cells includes a first conductivity-type semiconductor layer having an upper surface provided as a light emitting surface, an active layer, and a second conductivity-type semiconductor layer stacked in order on a lower surface of the first conductivity-type semiconductor layer. The spacer at least partially covers a side surface and a lower surface of each of the plurality of LED cells and has an inclined sidewall. The spacer includes a first contact hole coupled with a portion of the second conductivity-type semiconductor layer on the lower surface of each of the plurality of LED cells. The plurality of reflective electrodes are respectively disposed on the plurality of LED cells, and are electrically coupled with the portion of the second conductivity-type semiconductor layer through the first contact hole along the inclined sidewall of the spacer. The gap-fill insulating layer is filled in a space between the plurality of LED cells and at least partially covers the plurality of reflective electrodes. The gap-fill insulating layer includes a second contact hole coupled with each of the plurality of reflective electrodes on the lower surface of each of the plurality of LED cells. The first electrode is electrically coupled with the first conductivity-type semiconductor layer of each of the plurality of LED cells. The plurality of second electrodes is disposed on the gap-fill insulating layer, and are respectively electrically coupled with the plurality of reflective electrodes through the second contact hole.

Additional aspects may be set forth in part in the description which follows and, in part, may be apparent from the description, and/or may be learned by practice of the presented embodiments

### BRIEF DESCRIPTION OF DRAWINGS

The above and other aspects, features, and advantages of certain embodiments of the present disclosure may be more apparent from the following description taken in conjunction with the accompanying drawings, in which:
FIG. 1 is a perspective diagram illustrating a display apparatus, according to an example embodiment of the present disclosure;
FIG. 2 is a plan diagram illustrating a region "A" of the display apparatus illustrated in FIG. 1, according to an example embodiment of the present disclosure;
FIG. 3 is a cross-sectional diagram illustrating a display apparatus, according to an example embodiment of the present disclosure;
FIG. 4 is an enlarged diagram illustrating region "B" of the display apparatus illustrated in FIG. 3, according to an example embodiment of the present disclosure;
FIG. 5 is a diagram illustrating a driving circuit implemented in a display apparatus, according to an example embodiment of the present disclosure;
FIG. 6 is a cross-sectional diagram illustrating a display apparatus, according to an example embodiment of the present disclosure;
FIG. 7 is an enlarged diagram illustrating region "B1" of the display apparatus illustrated in FIG. 6, according to an example embodiment of the present disclosure;
FIG. 8 is a cross-sectional diagram illustrating an LED light source structure employed in a display apparatus, according to an example embodiment of the present disclosure;
FIG. 9 is a cross-sectional diagram illustrating a display apparatus, according to an example embodiment of the present disclosure;
FIG. 10 is an enlarged diagram illustrating region "B2" of the display apparatus illustrated in FIG. 9, according to an example embodiment of the present disclosure;
FIG. 11 is a cross-sectional diagram illustrating a display apparatus, according to an example embodiment of the present disclosure;
FIG. 12 is an enlarged diagram illustrating region "B3" of the display apparatus illustrated in FIG. 11, according to an example embodiment of the present disclosure;
FIGS. 13A to 13D are cross-sectional diagrams illustrating a portion of processes of a method of manufacturing a display apparatus, according to an example embodiment of the present disclosure;
FIGS. 14A to 14F are cross-sectional diagrams illustrating an example of a process for forming a spacer as illustrated in FIGS. 13A and 13B, according to an example embodiment of the present disclosure;
FIGS. 15A to 15E are cross-sectional diagrams illustrating an example of a process for forming a reflective electrode as illustrated in FIGS. 13A and 13B, according to an example embodiment of the present disclosure;
FIGS. 16A to 16C are cross-sectional diagrams illustrating the other portion of processes of a method of manufacturing a display apparatus, according to an example embodiment of the present disclosure;
FIGS. 17A to 17C are cross-sectional diagrams illustrating a portion of processes of a method of manufacturing a display apparatus, according to an example embodiment of the present disclosure;
FIGS. 18A to 18D are cross-sectional diagrams illustrating a portion of processes of a method of manufacturing a display apparatus, according to an example embodiment of the present disclosure; and
FIG. 19 is a diagram illustrating an electrode device including a display apparatus, according to an example embodiment of the present disclosure.

### DETAILED DESCRIPTION

The following description with reference to the accompanying drawings is provided to assist in a comprehensive understanding of embodiments of the present disclosure defined by the claims and their equivalents. Various specific details are included to assist in understanding, but these details are considered to be exemplary only. Therefore, those of ordinary skill in the art may recognize that various changes and modifications of the embodiments described herein may be made without departing from the scope of the disclosure. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", and the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", and the like may be used to distinguish components from each other and do not limit the present disclosure. For example, the terms "first", "second", "third", and the like may not necessarily involve an order or a numerical meaning of any form.

As used herein, when an element or layer is referred to as "covering", "overlapping", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

As used herein, each of the terms "AlN", "Al₂O₃", "AlON", "GaAs", "GIO", "GaN", "Ga₂ZnO₄", "HfO₂", "InₓAl_{y}Ga_{1-x-y}N", "InAs", "InₓGa₁₋ₓN", "InP", "In₄Sn₃O₁₂", "ITO", "ITO:Zn", "IZO", "KOH", "LiAlO₂", "LiGaO₂", "MgAl₂O₄", "MgF₂", "MgO", "SiC", "SiCN", "SiGe", "Si₃N₄", "SiO₂", "SiOC", "SiOₓC_{y}N_{z}", "SiOₓN_{y}", "SnO₂:Al", "SnO₂:F", "SnZnO₃", "TMAH", "Zn₍₁₋ₓ₎MgₓO", "ZrO₂", or the like may refer to a material made of elements included in each of the terms and is not a chemical formula representing a stoichiometric relationship.

Hereinafter, various embodiments of the present disclosure are described with reference to the accompanying drawings.

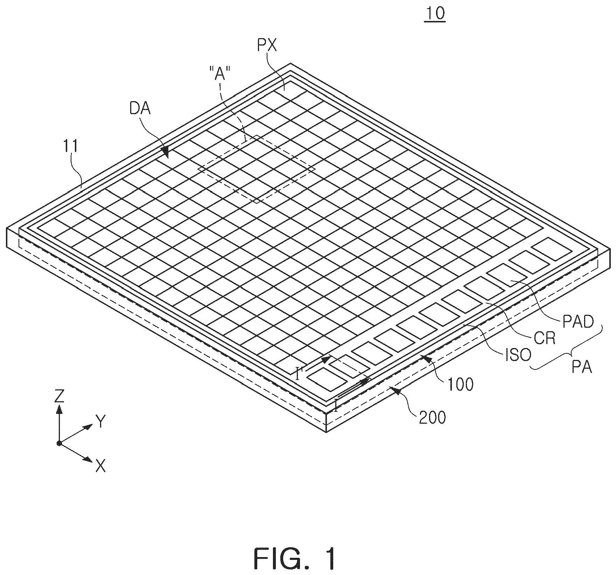

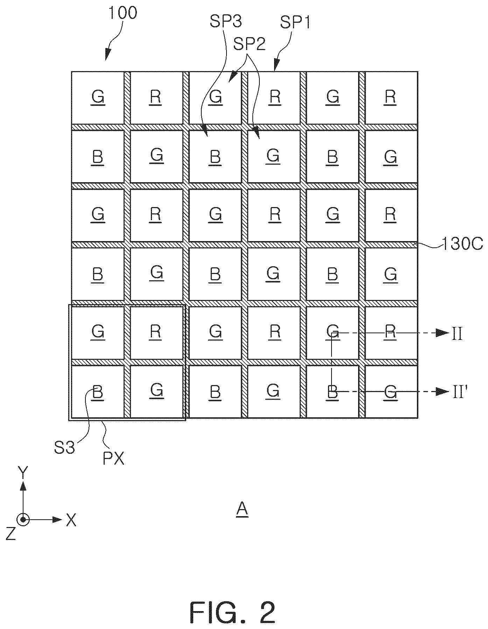

FIG. 1 is a perspective diagram illustrating a display apparatus, according to an example embodiment. FIG. 2 is a cross-sectional diagram illustrating a region "A1" of the display apparatus illustrated in FIG. 1 along an X-Y surface.

Referring to FIGS. 1 and 2, a display apparatus 10, according to the example embodiment, may include a circuit board 200 including driving circuits, and a pixel array 100 disposed on the circuit board 200 and having a plurality of pixels PX arranged thereon. Additionally, the display apparatus 10 may include a frame 11 surrounding the circuit board 200 and the pixel array 100.

The circuit board 200 may include driving circuits including thin film transistor (TFT) cells. In some example embodiments, the circuit board 200 may further include other circuits in addition to the driving circuits for the display apparatus. In some example embodiments, the circuit board 200 may include a flexible board, and the display apparatus 10 may be implemented as a display apparatus having a curved profile.

The pixel array 100 may include a display region DA and a peripheral region PA disposed on at least one side of the display region DA. The display region DA may include a light-emitting diode (LED) module for display. The plurality of pixels PX are arranged in the display region DA. The peripheral region PA may include pad regions PAD, a connection region CR connecting the plurality of pixels PX to the pad regions PAD, and an edge region ISO.

Each of the plurality of pixels PX may include sub-pixels (e.g., a first sub-pixel SP1, a second sub-pixel SP2, and a third sub-pixel SP3) configured to emit light of different colors to provide a color image. For example, the first to third sub-pixels SP1 to SP3 may be configured to emit red (R) light, green (G) light, and blue (B) light, respectively.

In some example embodiments, in each pixel PX (also referred to as a "pixel unit"), the first to third sub-pixels SP1 to SP3 may be arranged in a Bayer pattern. As illustrated in FIG. 2, each pixel PX may include first and third sub-pixels SP1 and SP3 (e.g., red sub-pixel R, blue sub-pixel B) arranged in a first diagonal direction and two second sub-pixels SP2 (e.g., green sub-pixels G) arranged in a second diagonal direction intersecting the first diagonal direction. In the example embodiment, in each pixel PX, the first to third sub-pixels SP1 to SP3 may be arranged in a 2×2 Bayer pattern. However, an example embodiment thereof is not limited thereto, and in another example embodiment, each pixel PX may be configured in another arrangement, such as 3×3 pattern and/or a 4×4 pattern. In some example embodiments, each pixel PX may include sub-pixels configured to emit light of a color other than the illustrated colors (e.g., red R, green G, blue B), for example, but not limited to, yellow light. In the pixel array 100 in FIG. 1, the plurality of pixels PX may be arranged in a 15×15 arrangement. However, the present disclosure is not limited in this regard. For example, the columns and rows may be implemented in any appropriate number, such as, but not limited to, 1,024×768 or 1,800× 1,350. For example, depending on a desired resolution and/or design constraints, the plurality of pixels PX may have a different arrangement.

The frame 11 may be configured as a guide structure surrounding the pixel array 100. The frame 11 may include at least one of materials such as, but not limited to, a polymer, a ceramic, a semiconductor, or a metal. For example, the frame 11 may include a black matrix. However, the frame 11 is not limited to a black matrix, and may include a white matrix and/or a structure of another color depending on a purpose and/or design constraints of the display apparatus 10. For example, the white matrix may include a reflective material and/or a scattering material. The display apparatus 10 in FIG. 1 may have a rectangular planar structure. However, the present disclosure is not limited in this regard, and the display apparatus 10 may have a different shape in example embodiments.

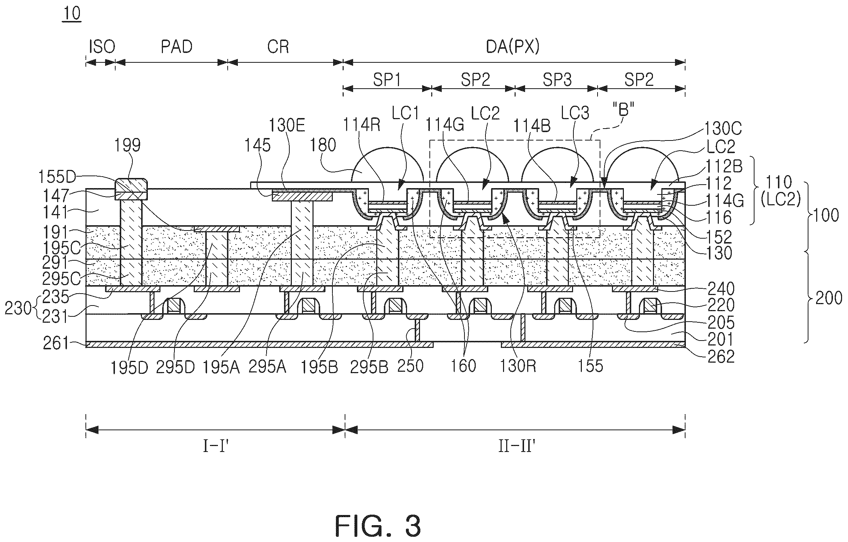

FIG. 3 is a cross-sectional diagram illustrating a display apparatus, according to an example embodiment, illustrating a cross-section I-I' of the peripheral region PA of the display apparatus in FIG. 1 and a cross-section II-II' of the display region DA of the display apparatus in FIG. 2.

A plurality of LED cells (e.g., a first LED cell LC1, a second LED cell LC2, and a third LED cell LC3 as shown in FIG. 3) may be arranged as micro-LED structures, respectively, corresponding to the first to third sub-pixels SP1 to SP3. The plurality of LED cells LC1 to LC3 may be arranged as a plurality of columns and a plurality of rows in a planar view, as shown in FIG. 2.

The plurality of LED cells LC1 to LC3 may be provided as light sources for the first to third sub-pixels SP1 to SP3. The first to third sub-pixels SP1 to SP3 may be configured to emit light of different colors as described above. In the example embodiment, the plurality of LED cells LC1 to LC3 may include active layers (e.g., a first (red) active layer 114R, a second (green) active layer 114G, and a third (blue) active layer 114B) configured to emit light of different wavelengths. Each of the first LED cells LC1 may include a first active layer 114R configured to emit red light (e.g., light having a wavelength of 620 nanometers (nm) to 660 nm) and may be provided as a red sub-pixel SP1. Each of the second LED cells LC2 may include a second active layer 114G configured to emit green light (e.g., light having a wavelength of 510 nm to 550 nm) and may be provided as a green sub-pixel SP2. Each of the third LED cells LC3 may include a third active layer 114B configured to emit blue light (e.g., light having a wavelength of 430 nm to 480 nm) and may be provided as a blue sub-pixel SP3.

The first to third active layers 114R to 114B may have different luminous efficiencies depending on the emitted wavelength. To implement smooth color reproduction of the display apparatus 10, the LED cell area may be varied and/or the configuration of the active layer (e.g., the number of quantum wells) may be changed to reduce the deviation between the amounts of light emitted from the different sub-pixels SP1 to SP3.

As described above, the first to third LED cells LC1 to LC3 may include a semiconductor stack 110 configured to emit light of different wavelengths and may be provided as light sources for the first to third sub-pixels SP1 to SP3.

As illustrated in FIG. 3, the semiconductor stack 110 may have a first surface (or lower surface) opposing the circuit board 200 and a second surface (or upper surface) disposed opposite thereto. In the example embodiment, the semiconductor stack 110 may include a first conductivity-type semiconductor base layer 112B, and a plurality of LED cells LC1 to LC3 disposed on the lower surface of the first conductivity-type semiconductor base layer 112B. The upper surface of the first conductivity-type semiconductor base layer 112B may be provided as a second surface of the semiconductor stack 110 (e.g., the light emitting surface).

Each of the plurality of LED cells LC1 to LC3 may include at least one of the first to third active layers 114R to 114B and a second conductivity-type semiconductor layer 116 stacked on a lower surface of a first conductivity-type semiconductor base layer 112B. The first conductivity-type semiconductor base layer 112B may be configured as a base layer shared by the first to third LED cells LC1 to LC3 and may provide a contact region for driving the plurality of LED cells LC1 to LC3. In the example embodiment, the first conductivity-type semiconductor base layer 112B may be formed to have a thickness to reduce light leakage effects while providing a contact region. In some example embodiments, a thickness of the first conductivity-type semiconductor base layer 112B may be in a range of 0.1 micrometer (µm) to 2 µm.

Each of the plurality of LED cells LC1 to LC3 employed in the example embodiment may further include a first conductivity-type semiconductor layer 112 between the first conductivity-type semiconductor base layer 112B and the first to third active layers 114R to 114B. The first conductivity-type semiconductor layer 112 may be and/or may include a portion obtained by etching the first conductivity-type semiconductor base layer 112B. The first to third active layers 114R to 114B of the first to third LED cells LC1 to LC3, respectively, may be configured to emit light of different wavelengths (e.g., red, green, and blue). In the example embodiment, the first to third active layers 114R to 114B of the first to third LED cells LC1 to LC3, respectively, may include quantum well layers having different indium (In) contents.

Each of the first conductivity-type semiconductor base layer 112B and the first conductivity-type semiconductor layer 112 may be and/or may include a nitride epitaxial layer having a composition of N-type InₓAl_{y}Ga_{1-x-y}N (where 0 ≤ x < 1, 0 ≤ y < 1, and 0 ≤ x + y < 1). For example, the first conductivity-type semiconductor layer 112 may be and/or may include, but not be limited to, at least one of silicon (Si), germanium (Ge), or carbon (C)-doped N-type nitride (e.g., n-GaN) layer. That is, the first conductivity-type semiconductor base layer 112B may include a high-concentration N-type nitride (n+-GaN) layer providing a contact region. The second conductivity-type semiconductor layer 116 may be a nitride semiconductor layer having a composition of P-type InₓAl_{y}Ga_{1-x-y}N (where 0 ≤ x < 1, 0 ≤ y < 1,0 ≤ x + y < 1). For example, the second conductivity-type semiconductor layer 116 may be and/or may include, but not be limited to, at least one of a P-type nitride (p-GaN) layer doped with magnesium (Mg), zinc (Zn), or the like. Each of the first conductivity-type semiconductor layer 112 and the second conductivity-type semiconductor layer 116 may be formed as an integrated layer, and/or may include a plurality of layers having different characteristics such as, but not limited to, a doping concentration and a composition.

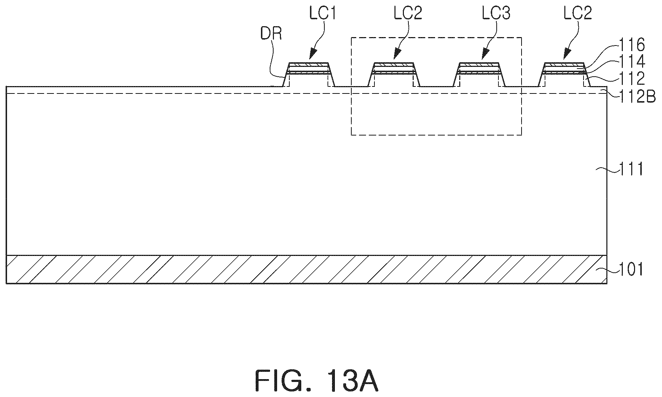

The semiconductor stacks 110 of the first to third LED cells LC1 to LC3 employed in the example embodiment may include nitride epitaxial layers grown on the same substrate. The growth substrate 101 (see FIG. 13A) may include a substrate for nitride single crystal growth, for example, at least one of sapphire (Al₂O₃), silicon (Si), silicon carbide (SiC), magnesium aluminate (MgAl₂O₄), magnesium oxide (MgO), lithium aluminate (LiAlO₂), lithium gallium oxide (LiGaO₂), gallium nitride (GaN), or the like. In some example embodiments, to improve crystallinity and light extraction efficiency of the nitride epitaxial layers, the growth substrate may have an uneven structure on at least a portion of an upper surface.

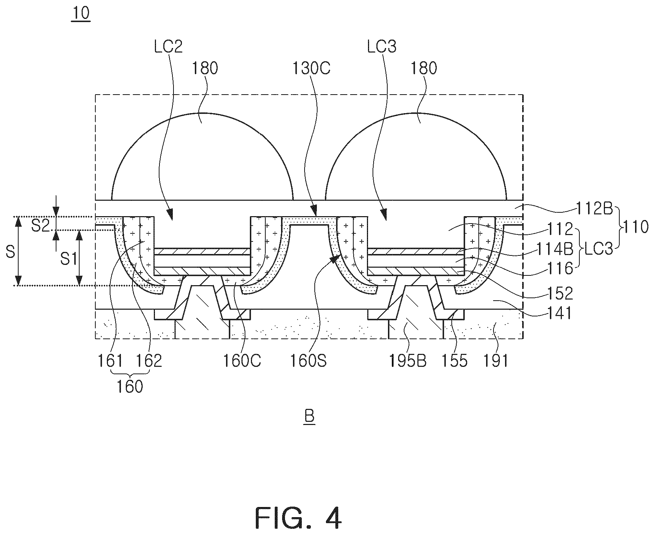

Referring to FIGS. 3 and 4, the plurality of LED cells LC1 to LC3 may include a contact electrode 152 disposed on the second conductivity-type semiconductor layers 116. The contact electrode 152 may include a transparent electrode. The transparent electrode may be and/or may include at least one of a transparent conductive oxide layer or a nitride layer. For example, the transparent electrode may be at least one of indium tin oxide (ITO or In₄Sn₃O₁₂), zinc-doped indium tin oxide (ITO:Zn), indium zinc oxide (IZO), gallium indium oxide (GIO), tin zinc oxide (SnZnO₃), fluorine-doped tin oxide (SnO₂:F), aluminum-doped tin oxide (SnO₂:Al), gallium-doped zinc oxide (Ga₂ZnO₄), or zinc magnesium oxide (Zn₍₁₋ₓ₎MgₓO, where 0 ≤ x ≤ 1).

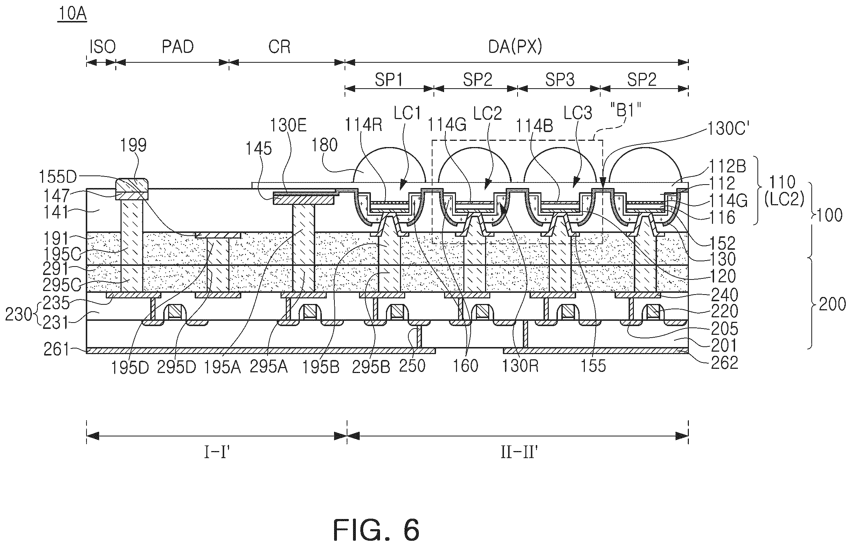

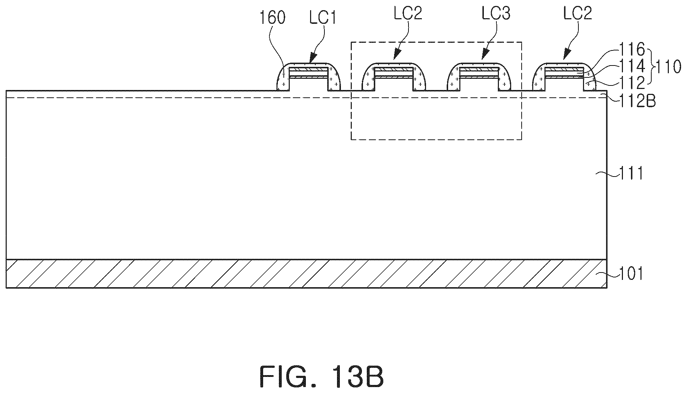

The first to third LED cells LC1 to LC3 employed in the example embodiment may have side surfaces that may be perpendicular and/or substantially perpendicular to the lower surface of the first conductivity-type semiconductor base layer 112B. For example, side surfaces of the first to third LED cells LC1 to LC3 may have an inclination angle in the range of 85° to 95°. Vertical side surfaces of the first to third LED cells LC1 to LC3 may be obtained by an etching process of removing a damage region on side surfaces of the LED cells, as described below with reference to FIGS. 13A and 13B. A defective region causing leakage current may be removed by this etching process. In some example embodiments, a lower surface of the first conductivity-type semiconductor base layer 112B (or the upper surface of the growth substrate (e.g., growth substrate 101 of FIG. 13A)) may be a (0001) crystal plane, and a side surface of each of the LED cells LC1 to LC3 may be an m-plane. In some example embodiments, a passivation layer may be formed to cover side surfaces and lower surfaces of the first to third LED cells LC1 to LC3, as described with reference to FIGS. 6, 7 and 8.

Referring to FIGS. 3 and 4, the pixel array 100 may include a reflective structure configured to emit light to the upper surface of the first to third LED cells LC1 to LC3.

The reflective structure employed in the example embodiment may include a spacer 160 having an inclined sidewall 160S and a reflective electrode 130 connected to the first conductivity-type semiconductor base layer 112B. As described above, when the reflective electrode 130 is formed along the vertical side surfaces of the LED cells LC1 to LC3, light may be trapped in the LED cells LC1 to LC3 and light may not be effectively extracted at a desired narrow beam angle.

In an embodiment, in order to potentially enhance the light collection effect when compared to a related LED cell, the spacer 160 may be formed on side surfaces and lower surfaces of the plurality of LED cells LC1 to LC3 and may provide an inclined sidewall 160S. As described above, by changing the surface, on which the reflective electrode 130 is formed, of the spacer 160 included in the example embodiment into an inclined curved surface, the reflective electrode 130 may form a reflective portion 130R having a structure similar to a bowl shape. Consequently, the reflective electrode 130 may effectively collect light generated from the LED cells LC1 to LC3 into a desired region.

Referring to FIG. 4, the sidewall 160S of the spacer 160 employed in the example embodiment may have an inclined portion S1, and the inclined portion S1 may extend from the cover portion 160C covering the lower surface of each of the plurality of LED cells LC1 to LC3 of the spacer 160 upwardly. As illustrated in FIG. 4, the sidewall 160S of the spacer 160 may have the inclined portion S1 from the cover portion 160C covering the lower surface of each of the plurality of LED cells LC1 to LC3 to at least a level higher than a level of the first to third active layers 114R to 114B. In some example embodiments, the inclined portion S1 may have a region of 50% or more (e.g., 80% or more) with respect to the entire height S of the sidewall 160S.

As described above, by expanding the inclined curved portion S1 of the spacer 160, the light capturing effect by the reflective electrode 130 formed on the spacer 160 may be further improved, when compared to a related LED cell.

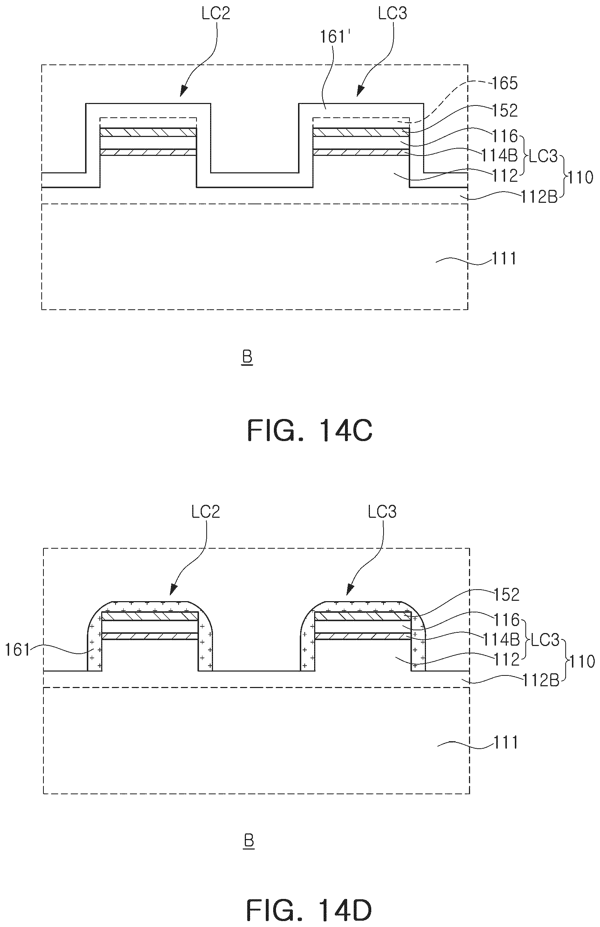

The expansion of the inclined portion S1 of the sidewall 160S may be implemented by sufficiently applying an anisotropic etching process such as, but not limited to, an etch back during the formation of the spacer 160, and/or by applying an additional etch back process after the re-deposition of the spacer material, as described with reference to FIGS. 14C to 14F. In some example embodiments, a portion S2 of the upper end of the sidewall 160S (e.g., a portion adjacent to the first conductivity-type semiconductor base layer 112B) may maintain a vertical and/or a substantially vertical side surface.

The spacer 160 employed in the example embodiment may include a plurality of spacer layers 161 and 162 obtained by repeatedly depositing and etching-back the spacer material.

Referring to FIG. 4, the spacer 160 may include a first spacer 161 having an inclined first sidewall surrounding each of side surfaces and lower surfaces of the plurality of LED cells LC1 to LC3, and a second spacer 162 disposed on the first spacer 161 and having an inclined second sidewall. The second spacer 162 may be disposed primarily on the first sidewall of the first spacer 161. The first and second sidewalls may have inclined profiles. An inclined portion of the second sidewall of the second spacer 162 may be increased further than the first sidewall of the first spacer 161 and may be provided as a final external sidewall 160S. The first and second spacers 161 and 162 may include silicon oxide (SiO₂), silicon oxycarbide (SiOC), silicon oxynitride (SiOₓN_{y}), silicon carbonate nitride (SiOₓC_{y}N_{z}), or the like. In some example embodiments, the first and second spacers 161 and 162 may include the same material (e.g., silicon oxide (SiO₂)). In this case, an interfacial surface between the first and second spacers 161 and 162 may not be visually distinct.

The reflective electrode 130 employed in the example embodiment may be disposed on the sidewall 160S of the spacer 160 and may have a bowl shape advantageous for light collection. As illustrated in FIGS. 3 and 4, the reflective electrode 130 may extend into a region of the first conductivity-type semiconductor base layer 112B between the plurality of LED cells LC1 to LC3 and may be provided as a first electrode driving the LED cells LC1 to LC3. The reflective electrode 130 may have a contact portion 130C connected to one region of the first conductivity-type semiconductor base layer 112B.

The contact portion 130C of the reflective electrode 130 provided as the first electrode may have structures connected to each other along a region between the plurality of LED cells LC1 to LC3. In a plan view, as illustrated in FIG. 2, the reflective electrode 130 (e.g., the contact portion 130C) may be a grid and/or mesh structure extending in the X-direction and the Y-direction and may be connected to each other. The side cross-section of the reflective electrode 130 may have an inverted U-shaped shape between the adjacent LED cells LC1 to LC3. The reflective electrode 130 may include a reflective electrode material, for example, at least one of silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), copper (Cu), titanium (Ti), tantalum (Ta), tungsten (W), or the like. In some example embodiments, the reflective electrode 130 may include a single layer or a multilayer structure.

Referring to FIG. 3, the reflective electrode 130 may have an extension portion 130E extending from the display region DA to the peripheral region PA. In the connection region CR, a common electrode 145 may be disposed on the extension portion 130E of the reflective electrode 130. The pad electrode 147 may be disposed in the pad region PAD, and may be disposed on the gap-fill insulating layer 141 similarly to the common electrode 145, and may be connected to the bonding pad 199 for connection to an external circuit on the pad electrode 147.

Referring to FIG. 4, the spacer 160 employed in the example embodiment may have a cover portion 160C covering lower surfaces of a plurality of LED cells LC1 to LC3. The cover portion 160C may protect the contact electrode 152 in an etch-back process of forming the spacer 160. Additionally, the reflective electrode 130 may further reflect light traveling to the lower surfaces of the LED cells LC1 to LC3 by partially extending to the cover portion 160C of the spacer 160. A contact hole may be formed in the cover portion 160C of the spacer 160 for connecting the connection electrode 155 to the contact electrode 152.

The pixel array 100 may further include a gap-fill insulating layer 141 disposed on the lower surface of the semiconductor stack 110 and covering the reflective electrode 130, and the contact hole may extend into the gap-fill insulating layer. The connection electrodes 155 may be connected to the contact electrodes 152 of the plurality of LED cells LC1 to LC3 through the contact holes, respectively. The connection electrodes 155 may be provided as individual electrodes for individually driving the plurality of LED cells LC1 to LC3.

The upper bonding structure 190 may include an upper bonding insulating layer 191 disposed on the lower surface of the gap-fill insulating layer 141, and upper bonding electrodes 195 electrically connected to the reflective electrode 130 and the connection electrodes 155, respectively, in the upper bonding insulating layer 191. The upper bonding electrodes 195 may be electrically connected to the reflective electrode 130 and the connection electrodes 155. The upper bonding electrodes 195 may have a shape similar to a post. Lower surfaces of the upper bonding electrodes 195 may be substantially coplanar with an lower surface of the upper bonding insulating layer 191. The coplanar surface may be provided as an adhesive surface for bonding to the circuit board 200 as a lower surface of the pixel array 100. The upper bonding electrodes 195 may include a conductive material, for example, copper (Cu). For example, the upper bonding insulating layer 191 may include at least one of silicon oxide (SiO₂), silicon nitride (Si₃N₄), silicon carbon nitride (SiCN), silicon oxycarbide (SiOC), silicon oxynitride (SiOₓN_{y}), silicon carbonate nitride (SiOₓC_{y}N_{z}), or the like.

As described above, the common electrode 145 and the pad electrode 147 may be disposed in the connection region CR and the pad regions PAD, respectively. The common electrode 145 may be provided as a common electrode structure for driving the LED cells LC1 to LC3 together with the reflective electrode 130. The pad electrode 147 may be disposed in the pad regions PAD and may be connected to a bonding pad 199 for connecting to an external circuit on the pad electrode 147.

The common electrode 145 and the pad electrode 147 may include at least one of a conductive material, for example, silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), or the like. As another example, the bonding pad 199 may include at least one of gold (Au), silver (Ag), nickel (Ni), or the like.

In the example embodiment, depending on connection objects, the upper bonding electrodes 195 may include a first upper bonding electrode 195A electrically connected to the reflective electrode 130, second upper bonding electrodes 195B electrically connected to the connection electrodes 155, and a third upper bonding electrode 195C connected to the pad electrode 147.

Referring to FIG. 3, the first upper bonding electrode 195A may penetrate the upper bonding insulating layer 191 and the gap-fill insulating layer 141 and may land on the common electrode 145, and may be commonly connected to one side (e.g., the first conductivity-type semiconductor base layer 112B) of each of the LED cells LC1 to LC3 through the common electrode 145 and the reflective electrode 130. The second upper bonding electrodes 195B may penetrate the upper bonding insulating layer 191 and may land on the connection electrode 155, respectively, and may be individually connected to the other sides (e.g., the second conductivity-type semiconductor layer 116) of the LED cells LC1 to LC3 through the connection electrode 155 and the contact electrode 152, respectively. Additionally, the third upper bonding electrode 195C may penetrate the upper bonding insulating layer 191 and the gap-fill insulating layer 141 and may land on the pad electrode 147, and may be connected to the bonding pad 199 for connecting to an external circuit through the pad electrode 147.

Referring to FIG. 3, the circuit board 200 employed in the example embodiment may include a device substrate 201 in which elements 220 for a driving circuit are disposed, and a lower bonding structure 290 disposed on the device substrate 201. The circuit board 200 may include an interlayer connection structure 230 between the device substrate 201 and the lower bonding structure 290. The interlayer connection structure 230 may include an interconnection insulating layer 231 on the device substrate 201 and interconnection circuits 235 electrically connected to the elements 220 for the driving circuit in the interconnection insulating layer 231. The elements 220 for the driving circuit may include thin film transistor (TFT) cells.

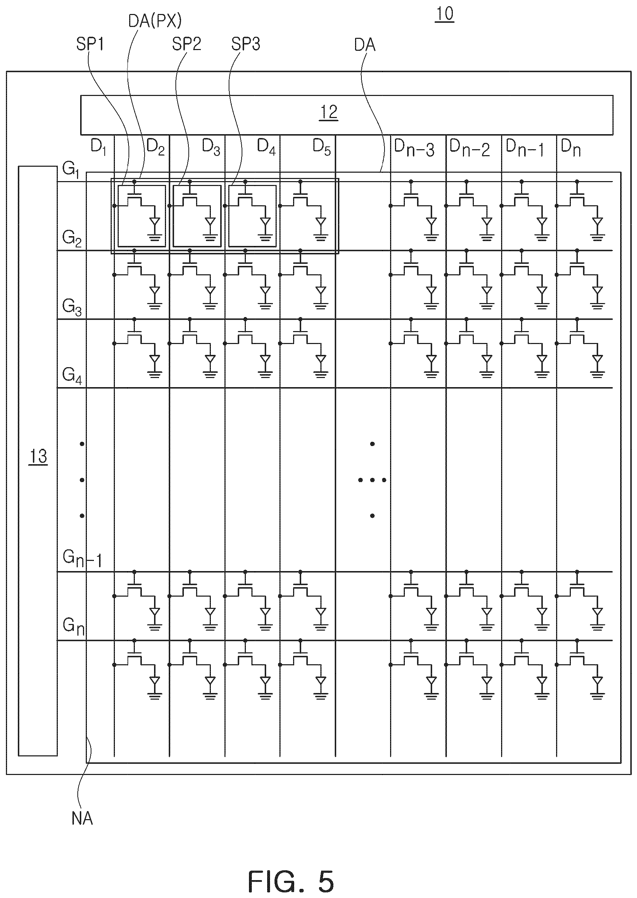

The device substrate 201 may be and/or may include a semiconductor substrate including impurity regions, such as, source/drain regions 205. The device substrate 201 may include a semiconductor, such as silicon (Si) or germanium (Ge), or a compound semiconductor, such as silicon-germanium (SiGe), silicon carbide (SiC), gallium arsenide (GaAs), indium arsenide (InAs), indium phosphide (InP), or the like. The driving circuit may include circuitry for controlling driving of a pixel, and/or a sub-pixel. The source region 205 of the TFT cells may be electrically connected to one side of the LED cells LC1 to LC3 through the interlayer connection structure 230 and the lower bonding structure 290. For example, the drain region 205 of the TFT cells may be connected to a data line through the interconnection circuit 235. The gate electrodes of the TFT cells may be connected to a gate line through the interconnection circuit 235. The circuit configuration and operation are described with reference to FIG. 5.

The lower bonding structure 290 may include a lower bonding insulating layer 291 and lower bonding electrodes 295 disposed in the lower bonding insulating layer 291, and electrically connected to the driving circuit. The lower bonding electrodes 295 may be electrically connected to the driving circuit through the interconnection circuits 235. For example, the lower bonding electrodes 295 may be provided as pillar structures. Upper surfaces of the lower bonding electrodes 295 may be substantially coplanar with an upper surface of the lower bonding insulating layer 291. The coplanar surface may be provided as an adhesive surface for bonding with the pixel array 100 as an upper surface of the circuit board 200. The lower bonding electrodes 295 may include a conductive material, for example, copper (Cu). For example, the lower bonding insulating layer 291 may include at least one of silicon oxide (SiO₂), silicon nitride (Si₃N₄), silicon carbon nitride (SiCN), silicon oxycarbide (SiOC), silicon oxynitride (SiOₓN_{y}), silicon carbonate nitride (SiOₓC_{y}N_{z}), or the like.

The lower bonding electrodes 295 of the circuit board 200 and the upper bonding electrodes 195 of the pixel array 100 may be bonded to each other and may provide an electrical connection path between the circuit board 200 and the pixel array 100. Additionally, the upper bonding insulating layer 191 of the pixel array 100 may be bonded to the lower bonding insulating layer 291 of the circuit board 200.

As described above, the circuit board 200 and the pixel array 100 may be coupled to each other by bonding between the lower bonding electrodes 295 and the upper bonding electrodes 195 and the bonding between the lower bonding insulating layer 291 and the upper bonding insulating layer 191. The bonding between the lower bonding electrodes 295 and the upper bonding electrodes 195 may be, for example, copper (Cu)-copper (Cu) bonding, and the bonding between the lower bonding insulating layer 291 and the upper bonding insulating layer 191 may be dielectric-dielectric bonding, for example, dielectric-dielectric bonding such as, but not limited to, SiCN-SiCN bonding. The circuit board 200 and the pixel array 100 may be bonded to each other by hybrid bonding including copper (Cu)-copper (Cu) bonding and dielectric-dielectric bonding, and may be bonded to each other without an adhesive layer.

Depending on the connection object, similarly to the upper bonding electrodes 195, the lower bonding electrodes 295 may be divided into lower bonding electrodes (e.g., a first lower bonding electrode 295A, a second lower bonding electrode 295B, and a third lower bonding electrode 295C), respectively.

That is, the first lower bonding electrode 295A may be bonded to the first upper bonding electrode 195A, and may electrically connect the reflective electrode 130 to the driving circuit through the common electrode 145. The second lower bonding electrodes 295B may be bonded to the second upper bonding electrodes 195B, respectively, and may electrically connect the connection electrode 155, which may be an individual electrode, to the driving circuit.

As described above, by bonding the first upper and lower bonding electrodes 195A and 295A to each other and bonding the second upper and lower bonding electrodes 195B and 295B to each other, the plurality of LED cells LC1 to LC3 may be individually driven and may be connected to the driving circuit.

Additionally, the third lower bonding electrode 295C may be bonded to the third upper bonding electrode 195C and may electrically connect the bonding pad 199 to the driving circuit through the pad electrode 147.

In the example embodiment, the lower bonding electrodes 295 may further include a lower dummy bonding electrode 295D not connected to the driving circuit. Similarly, the upper bonding electrodes 195 may further include an upper dummy bonding electrode 195D connected to the lower dummy bonding electrode 295D and not connected to the plurality of LED cells LC1 to LC3. The upper and lower dummy bonding electrodes 195D and 295D may be arranged at a uniform distance from the upper and lower bonding electrodes 195 and 295 throughout the entire area. In some example embodiments, the upper dummy bonding electrode 195D may be formed on a dummy pad 155D not connected to the plurality of LED cells LC1 to LC3, and the dummy pad 155D may be formed with the connection electrodes 155.

Referring to FIGS. 3 and 4, the microlenses 180 may be disposed on each of the LED cells LC1 to LC3 and may shape and direct light emitted from the LED cells LC1 to LC3. The microlenses 180 may be configured to control a beam angle of the light emitted from the LED cells LC1 to LC3. In the example embodiment, the microlenses 180 may be disposed on the first conductivity-type semiconductor base layer 112B The microlenses 180 may have a diameter larger than widths of the LED cells LC1 to LC3 in the X-direction and Y-direction, for example.

The microlenses 180 may be formed of, for example, but not limited to, a transparent photoresist material or a transparent resin film, such as a UV-curable resin film. The microlenses 180 employed in the example embodiment may have the same shape and size, but in some example embodiments, the microlenses 180 may have different shapes and/or different sizes depending on the areas of the first to third LED cells LC1 to LC3.

FIG. 5 is a diagram illustrating a driving circuit implemented in a display apparatus, according to an example embodiment.

FIG. 5 illustrates a circuit diagram of a display apparatus 10 in which n×n sub-pixels are arranged, where n is a positive integer greater than one (1). The first to third sub-pixels SP1 to SP3 may receive data signals through data lines (e.g., a first data line D1, a second data line D2, a third data line D3, a fourth data line D4, a fifth data line D5, to an (n-3)-th data line Dₙ₋₃, an (n-2)-th data line Dₙ₋₂, an (n-1)-th data line Dₙ₋₁, and an n-th data line Dₙ), which may be paths in a vertical direction, for example, a column direction, respectively. The first to third sub-pixels SP1 to SP3 may receive control signals, that is, gate signals, through gate lines (e.g., a first gate line G1, a second gate line G2, a third gate line G3, a fourth gate line G4, to an (n-1)-th gate line Gₙ₋₁, and an n-th gate line Gₙ), which may be paths in a horizontal direction, for example, a row direction.

The plurality of pixels PX including the first to third sub-pixels SP1 to SP3 may provide a display region DA, and the display region DA may be provided as a display region for a user as an active region. An inactive region NA (or the peripheral region PA) may be formed along one or more edges of the display region DA. The inactive region NA may extend along an outer perimeter of a panel of the display apparatus 10.

The first and second driver circuits 12 and 13 may be employed to control operation of the pixels PX, that is, the first to third sub-pixels SP1 to SP3. A portion and/or the entirety of the first and second driver circuits 12 and 13 may be implemented on a circuit board 200. The first and second driver circuits 12 and 13 may be configured as an integrated circuit, a thin film transistor (TFT) panel circuit, or other suitable circuits, and may be disposed in the inactive region NA of the display apparatus 10. The first and second driver circuits 12 and 13 may include a microprocessor, a memory such as storage, a processing circuit, and/or a communication circuit.

To display an image by the pixels PX, the first driver circuit 12 may supply image data to first to n-th data lines D1 to Dₙ while sending a clock signal and other control signals to the second driver circuit 13, which may be a gate driver circuit. The second driver circuit 13 may be implemented using an integrated circuit and/or a thin film transistor (TFT) circuit. Gate signals for controlling the first to third sub-pixels SP1 to SP3 arranged in the row direction may be transmitted through first to n-th gate lines G1 to Gₙ of the display apparatus 10.

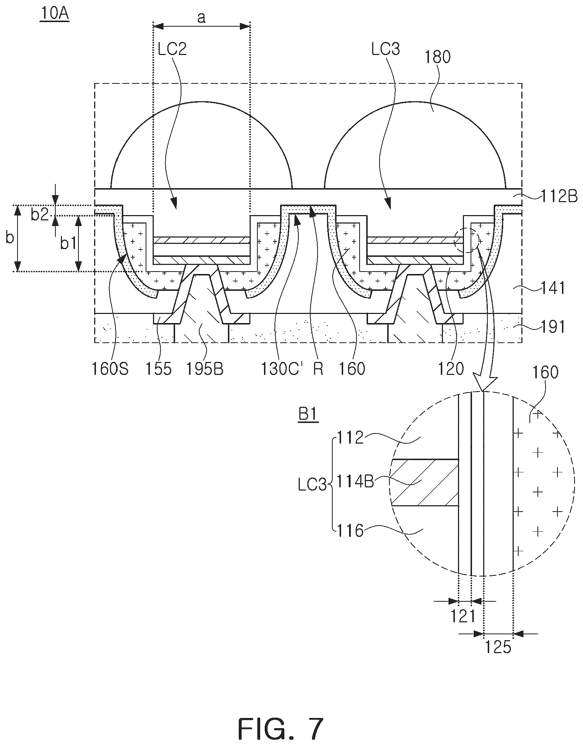

FIG. 6 is a cross-sectional diagram illustrating a display apparatus, according to an example embodiment. FIG. 7 is an enlarged diagram illustrating region "B1" of the display apparatus illustrated in FIG. 6, according to an example embodiment. The display apparatus 10A of FIGS. 6 and 7 may include and/or may be similar in many respects to the display apparatus 10 described above with reference to FIGS. 1 to 5, and may include additional features not mentioned above. Consequently, repeated descriptions of the display apparatus 10A described above with reference to FIGS. 1 to 5 may be omitted for the sake of brevity.

Referring to FIGS. 6 and 7, the display apparatus 10A, according to the example embodiment, when compared to the display apparatus 10 illustrated in FIGS. 1 to 5, may include a configuration in which a passivation layer 120 is added to surfaces of the plurality of LED cells LC1 to LC3, and a configuration in which the first conductivity-type semiconductor base layer 112B further has a recess R.

The display apparatus 10A employed in the example embodiment may further include a passivation layer 120 covering a side surface and a lower surface of each of the plurality of LED cells LC1 to LC3 below the spacer 160. The passivation layer 120 may be formed to cover side surfaces and upper surfaces of the first to third LED cells LC1 to LC3. In the example embodiment, the passivation layer 120 may be formed to a region of the first conductivity-type semiconductor base layer 112B between the first to third LED cells LC1 to LC3. Additionally, the passivation layer 120 may extend to the region of the first conductivity-type semiconductor base layer 112B disposed in the peripheral region PA. That is, the passivation layer 120 may be disposed to cover the lower surface of the first conductivity-type semiconductor base layer 112B in the connection region CR and the pad regions PAD (e.g., in the peripheral region PA). For example, the passivation layer 120 may include at least one of an insulating material, such as, but not limited to, silicon oxide (SiO₂), silicon nitride (Si₃N₄), silicon carbon nitride (SiCN), silicon oxycarbide (SiOC), silicon oxynitride (SiOₓN_{y}), silicon carbonate nitride (SiOₓC_{y}N_{z}), hafnium oxide (HfOₓ), aluminum oxide (Al₂O₃), zirconium oxide (ZrOₓ), aluminum nitride (AlN), or the like.

Referring to FIG. 7, the passivation layer 120 may include a first insulating layer 121 in contact with surfaces of the plurality of LED cells LC1 to LC3, and a second insulating layer 125 on the first insulating layer 121. The first insulating layer 121 may be provided as a layer for curing defects on surfaces of the plurality of LED cells LC1 to LC3, particularly, the side surface of a nitride epitaxial layer. For example, the first insulating layer 121 may include at least one of zirconium oxide (ZrO₂), aluminum oxide (Al₂O₃), hafnium oxide (HfO₂), or the like. The first insulating layer 121 may be conformally formed along surfaces of the LED cells LC1 to LC3. For example, the first insulating layer 121 may be formed by atomic layer deposition (ALD). In some example embodiments, the first insulating layer 121 may have a multilayer structure. For example, the first insulating layer 121 may include a multilayer structure of zirconium oxide (ZrO₂), aluminum oxide (Al₂O₃), and zirconium oxide (ZrO₂). Each layer of the multilayer structure may have a thickness in a range of 1 nm to 10 nm. For example, the second insulating layer 125 may include at least one of silicon oxide (SiO₂), silicon nitride (Si₃N₄), silicon carbon nitride (SiCN), silicon oxycarbide (SiOC), silicon oxynitride (SiOₓN_{y}) silicon carbonate nitride (SiOₓC_{y}N_{z}), or the like.

Referring to FIG. 7, a region of the first conductivity-type semiconductor base layer 112B between the plurality of LED cells LC1 to LC3 may further have the recess R. The reflective electrode 130 may have a contact portion 130C' connected to a bottom of the recess R. A highly doped first conductivity-type semiconductor layer (e.g., n+-GaN) may be exposed at the bottom of the recess R. In the example embodiment, the recess R may refer to a region between adjacent spacers 160. The region of the first conductivity-type semiconductor base layer 112B between the plurality of LED cells LC1 to LC3 may include regions disposed by the spacer 160, and a recess R between the regions. The reflective electrode 130 may be connected to the bottom of the recess R along a sidewall of the spacer 160.

As described above, in the example embodiment, even when the height b1 of the LED cells LC1 to LC3 is formed relatively small, the contact portion 130C' may be exposed through additional etching during the formation of recess. A depth b to the desired contact portion 130C' from the lower surface of the passivation layer 120 may be the sum of the height b1 of the plurality of LED cells LC1 to LC3 and the depth b2 of the recess R.

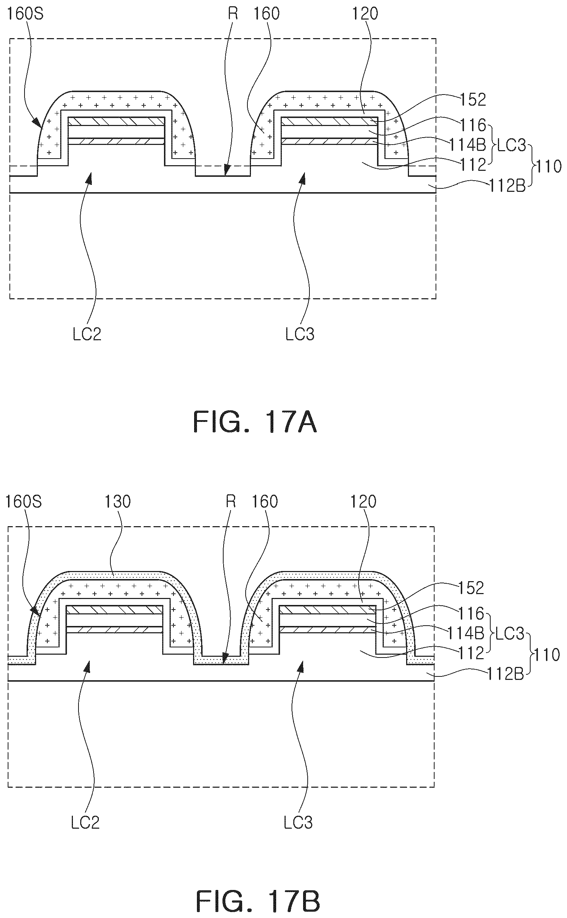

Accordingly, even when the plurality of LED cells LC1 to LC3 are formed at a relatively low level, the contact portion 130C' may be exposed using an additional recess R. Accordingly, the plurality of LED cells LC1 to LC3 may be formed to have a relatively small aspect ratio. For example, the aspect ratio (e.g., b1/a) of the plurality of LED cells LC1 to LC3 may be one (1) or less. The formation of the recess R may be implemented using adjacent spacers 160 as a mask, as described with reference to FIG. 17B.

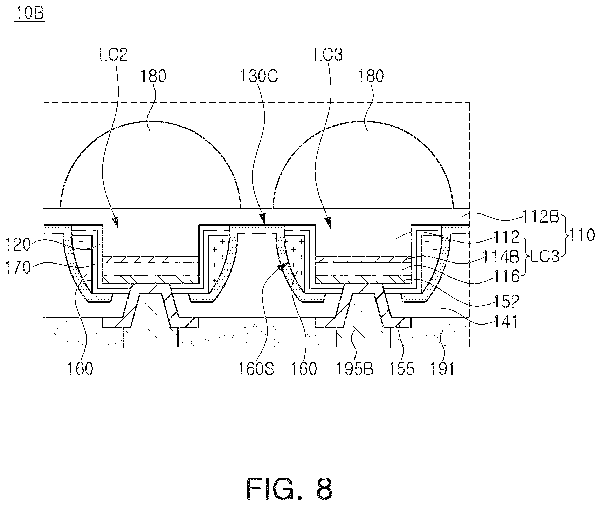

FIG. 8 is a cross-sectional diagram illustrating an LED light source structure employed in a display apparatus, according to an example embodiment. The display apparatus 10B of FIG. 8 may include and/or may be similar in many respects to the display apparatus 10 described above with reference to FIGS. 1 to 5, and may include additional features not mentioned above. Consequently, repeated descriptions of the display apparatus 10 described above with reference to FIGS. 1 to 5 may be omitted for the sake of brevity

Referring to FIG. 8, the display apparatus 10B, according to the example embodiment, when compared to the display apparatus 10 illustrated in FIGS. 1 to 5, may include configuration in which a passivation layer 120 and an etching stop layer 170 are added to the surfaces of a plurality of LED cells LC1 to LC3, and a configuration in which the passivation layer 120 and the etching stop layer 170 cover the lower surface of a plurality of LED cells LC1 to LC3 instead of a spacer 160.

The display apparatus 10B employed in the example embodiment may further include a passivation layer 120 covering a side surface and a lower surface of each of the plurality of LED cells LC1 to LC3 on the spacer 160. The passivation layer 120 may be formed to cover side surfaces and lower surfaces of the first to third LED cells LC1 to LC3. The passivation layer 120 employed in the example embodiment may be a layer for curing defects of the side surface of the nitride epitaxial layer, and may include, for example, at least one of zirconium oxide (ZrO₂), aluminum oxide (Al₂O₃), hafnium oxide (HfO₂), or the like.

The display apparatus 10B employed in the example embodiment may further include an etching stop layer 170 covering a region of the first conductivity-type semiconductor base layer 112B and a side surface and a lower surface of each of the plurality of LED cells LC1 to LC3 on. In the example embodiment, the etching stop layer 170 may include a material different from the composition material of the spacer 160. For example, the etching stop layer 170 may include silicon nitride (Si₃N₄), silicon oxynitride (SiOₓN_{y}), aluminum oxide (Al₂O₃), aluminum oxynitride (AlON), aluminum nitride (AlN), or the like. The etching stop layer 170 may be formed to extend to the region of the first conductivity-type semiconductor base layer 112B and may be used as an etching stop layer in an etch-back process of forming the spacer.

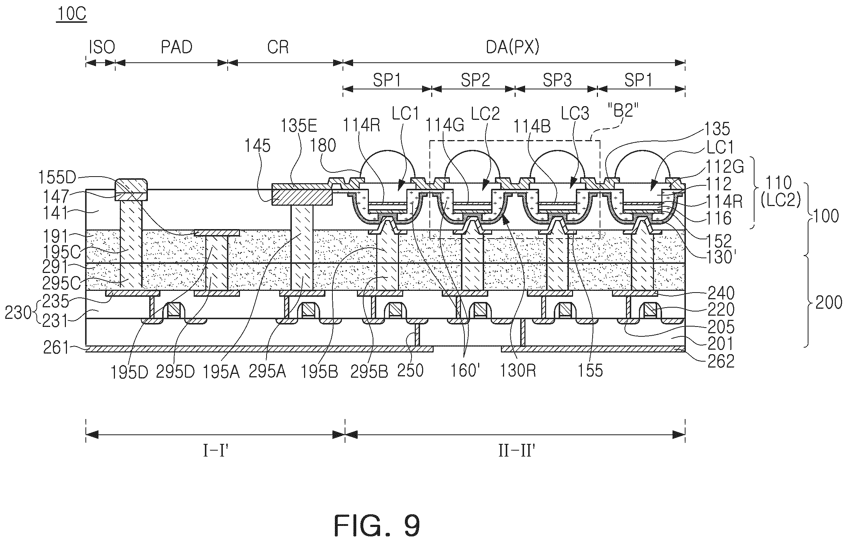

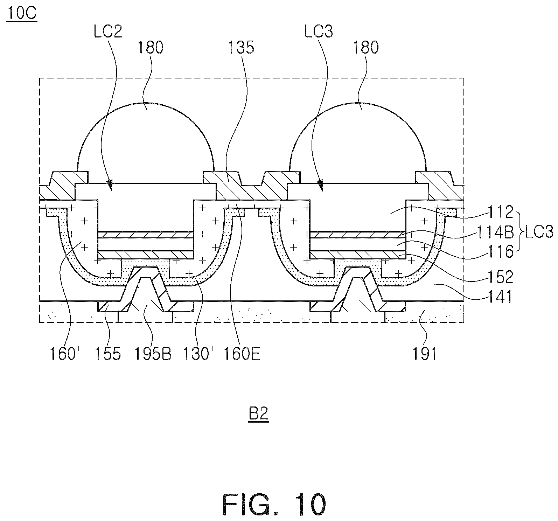

FIG. 9 is a cross-sectional diagram illustrating a display apparatus, according to an example embodiment. FIG. 10 is an enlarged diagram illustrating region "B2" of the display apparatus illustrated in FIG. 9, according to an example embodiment. The display apparatus 10C of FIGS. 9 and 10 may include and/or may be similar in many respects to the display apparatus 10 described above with reference to FIGS. 1 to 5, and may include additional features not mentioned above. Consequently, repeated descriptions of features of the display apparatus 10C already described above with reference to FIGS. 1 to 5 may be omitted for the sake of brevity.

Referring to FIGS. 9 and 10, the display apparatus 10C, according to the example embodiment, when compared to the display apparatus 10 illustrated in FIGS. 1 to 5, may include a configuration in which a spacer 160' has a portion 160E extending from a plurality of LED cells LC1 to LC3, a configuration in which a reflective electrode 130 is used as a portion of a second electrode structure, the configuration in which the plurality of LED cells LC1 to LC3 are isolated from each other, and a configuration in which a first electrode 135 is connected to upper surfaces of the plurality of LED cells LC1 to LC3.

In the example embodiment, each of the plurality of LED cells LC1 to LC3 may include semiconductor stacks 110 isolated from each other. Referring to FIGS. 9 and 10, each of the plurality of LED cells LC1 to LC3 may include a first conductivity-type semiconductor layer 112 having an upper surface provided as a light emitting surface, and first to third active layers 114R to 114B and a second conductivity-type semiconductor layer 116 stacked in order on a lower surface of the first conductivity-type semiconductor layer 112.

In the example embodiment, the spacer 160' may cover a side surface and a lower surface of each of the plurality of LED cells LC1 to LC3, and may have an inclined sidewall 160S. However, in the example embodiment, the spacer 160' may have a portion 160E extending between the plurality of LED cells LC1 to LC3. The extended portion 160E of the spacer 160' may prevent electrical connection between the reflective electrodes 130' and the first conductivity-type semiconductor base layers 112B.

In the example embodiment, the reflective electrodes 130 may be disposed on the spacer 160' and may be used as a portion of the second electrode structure. The reflective electrodes 130 may be isolated from each other and may be disposed on the LED cells LC1 to LC3, respectively. As illustrated in FIG. 10, the reflective electrodes 130 may extend to the contact holes of the spacer 160 and may be connected to the contact electrodes 152, respectively. The connection electrodes 155 may be connected to the reflective electrodes 130, respectively, through the contact holes of the gap-fill insulating layer 141. As described above, the reflective electrodes 130 may be used as individual electrodes for driving the LED cells LC1 to LC3 together with the connection electrodes 155.

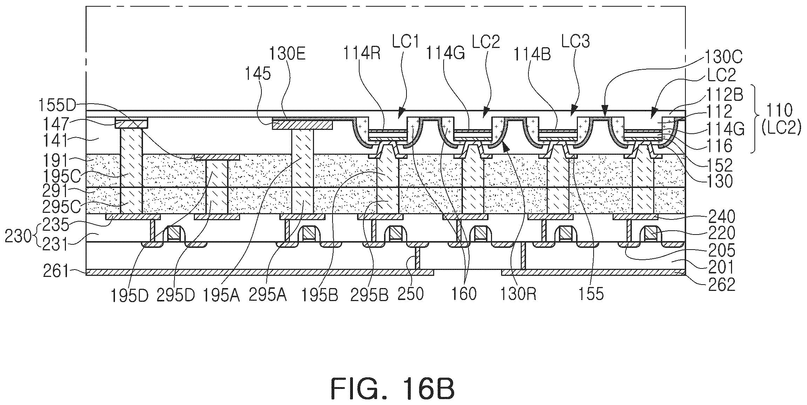

In the example embodiment, the plurality of LED cells LC1 to LC3 may be isolated from each other. The cell separation structure may be implemented by an additional etching processthat isolates the first conductivity-type semiconductor base layer for each of the plurality of LED cells LC1 to LC3 after a process of removing the growth substrate, as described with reference to FIG. 16B.

In the example embodiment, the first electrode 135 may be disposed on an upper surface of the pixel array 100. The first electrode 135 may be connected to a portion (e.g., an edge) of the upper surfaces of the plurality of LED cells LC1 to LC3 along a region between the plurality of LED cells LC1 to LC3. The first electrode 135 may be used as a common electrode for the plurality of LED cells LC1 to LC3. The first electrode 135 may have a grid or mesh view, similarly to the aforementioned example embodiment.

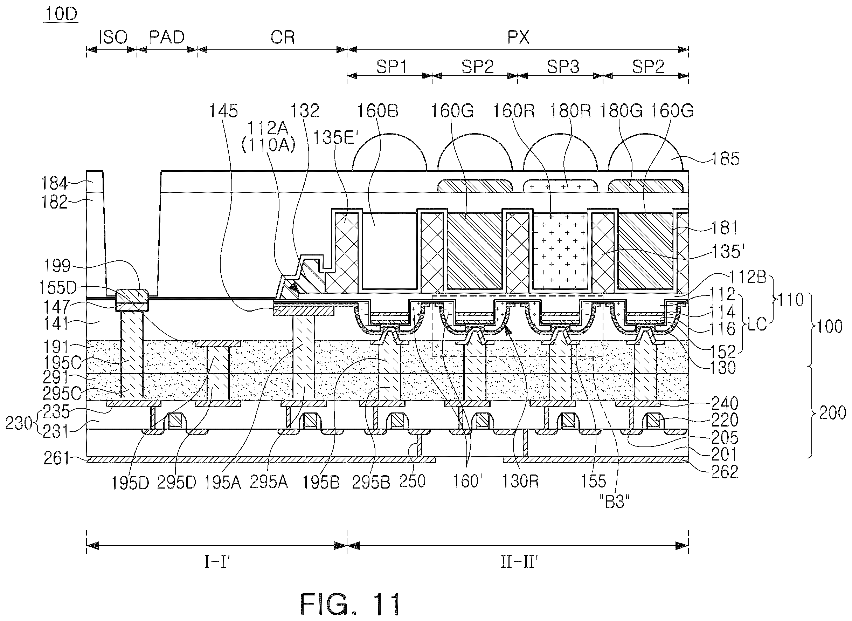

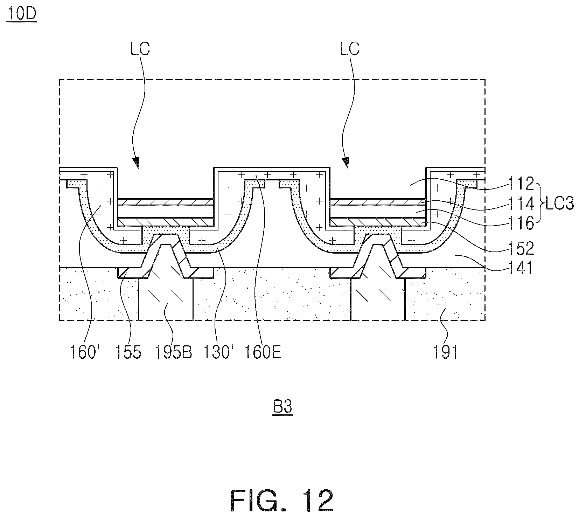

FIG. 11 is a cross-sectional diagram illustrating a display apparatus, according to an example embodiment. FIG. 12 is an enlarged diagram illustrating region "B3" of the display apparatus illustrated in FIG. 9, according to an example embodiment. The display apparatus 10D of FIGS. 11 and 12 may include and/or may be similar in many respects to the display apparatus 10 described above with reference to FIGS. 1 to 5, and may include additional features not mentioned above. Consequently, repeated descriptions of features of the display apparatus 10D already described above with reference to FIGS. 1 to 5 may be omitted for the sake of brevity

Referring to FIGS. 11 and 12, the display apparatus 10D, according to the example embodiment, when compared to the display apparatus 10 illustrated in FIGS. 1 to 5, may include a configuration in which a spacer 160' has a portion 160E extending from a plurality of LED cells LC, a configuration in which a reflective electrode 130' is used as a portion of a second electrode structure, a configuration in which a plurality of LED cells LC are configured to emit light of the same wavelength, a configuration in which a first electrode 135' is provided as a barrier wall structure, and a configuration in which a wavelength conversion structure for first to third sub-pixels SP1 to SP3 is provided.

In the example embodiment, the spacer 160' may have an extended portion 160E between the plurality of LED cells LC. The extended portion 160E of the spacer 160' may prevent electrical connection between the reflective electrodes 130' and the first conductivity-type semiconductor base layer 112B. Additionally, the reflective electrodes 130' may be disposed on the spacer 160' and may be used as a portion of the second electrode structure. As illustrated in FIG. 12, the reflective electrodes 130' may extend into the contact holes of the spacer 160' and may be connected to the contact electrodes 152, respectively. The connection electrodes 155 may be connected to the reflective electrodes 130', respectively, through the contact holes of the gap-fill insulating layer 141. As described above, the reflective electrodes 130' may be used as individual electrodes for driving the LED cells LC together with the connection electrodes 155.

In the example embodiment, the plurality of LED cells LC may include the same semiconductor stack to emit light of the same wavelength (e.g., blue). For example, the active layer 114 of the plurality of LED cells LC may have multiple quantum well (MQW) structures configured to emit light of the same wavelength.

The plurality of LED cells LC may be connected to each other by the first conductivity-type semiconductor base layer 112B. As described above, the upper surface of the first conductivity-type semiconductor base layer 112B may be provided as a contact region. The conductive barrier wall structure 135' may be disposed on an upper surface of the first conductivity-type semiconductor base layer 112B and may be in direct contact with the first conductivity-type semiconductor base layer 112B. In this arrangement, the conductive barrier wall structure 135' may be provided as a first electrode for each LED cell LC. The conductive barrier wall structure 135' may include a metal material for ohmic contact with a first conductivity-type semiconductor base layer 112B. The conductive barrier wall structure 135' formed of a metal material may be provided as a light blocking structure to prevent optical interference between the first to third sub-pixels SP1 to SP3. For example, the conductive barrier wall structure 135' may include silver (Ag), chromium (Cr), nickel (Ni), titanium (Ti), aluminum (Al), rhodium (Rh), ruthenium (Ru), or a combination thereof. The conductive barrier wall structure 135' may be provided as a single-layer and/or a multilayer structure.

Referring to FIG. 11, the conductive barrier wall structure 135' employed in the example embodiment may have a grid or mesh shape extending in the X-direction and Y-direction along regions between the first to third sub-pixels SP1 to SP3 on an upper surface of the semiconductor stack 110.

The conductive barrier wall structure 135' may be electrically connected to the first conductivity-type semiconductor base layer 112B in the region between the LED cells LC.

The conductive barrier wall structure 135' may have an edge region 135E' extending to the peripheral region PA (e.g., the connection region CR) disposed on one side of the display region DA in which the pixels PX are arranged. As described above, the conductive barrier wall structure 135' may be in direct contact with the first conductivity-type semiconductor base layer 112B, and the edge region 135E' of the conductive barrier wall structure 135' may be connected to the common electrode 145. In the example embodiment, the interconnection portion 132 may be configured to connect the edge region 135E' to the exposed region of the common electrode 145.

In the example embodiment, a transparent insulating film 181 may be formed on an upper surface and sidewalls of the conductive barrier wall structure 135. For example, the transparent insulating film 181 may include at least one of silicon oxide (SiO₂) magnesium fluoride (MgF₂), or the like. In the sub-pixel spaces of the conductive barrier wall structure 135' on which the transparent insulating film 181 is formed, wavelength conversion portions (e.g., a first wavelength conversion portion 160R, a second wavelength conversion portion 160G, and a third wavelength conversion portion 160B) for colors of the first to third sub-pixels SP1 to SP3, respectively, may be formed. The first to third wavelength conversion portions 160R to 160B may be disposed to correspond to the LED cells LC. The first to third wavelength conversion portions 160R to 160B may include a wavelength conversion material for converting the wavelength of light emitted from the LED cells LC to generate final light of a desired color from each of the first to third sub-pixels SP1 to SP3. The wavelength conversion material may include a phosphor and/or a quantum dot, and the first to third wavelength conversion portions 160R to 160B may be obtained by filling a liquid binder resin in which the wavelength conversion material is dispersed in each sub-pixel space and curing the material.

When the active layer 114 of the plurality of LED cells LC is configured to emit blue light, the first wavelength conversion portion 160R may be configured to convert blue light into red light, and the second wavelength conversion portion 160G may be configured to convert blue light into green light. However, the third wavelength conversion portion 160B applied to the sub-pixel space for the blue sub-pixel may be replaced with a transparent material such as a transparent resin.

The sealing layer 182 may be disposed to cover upper surfaces of the first to third wavelength conversion portions 160R to 160B. The sealing layer 182 may function as a protective layer preventing degradation of the first to third wavelength conversion portions 160R to 160B. In some example embodiments, the sealing layer 182 may not be provided. First and second color filters 180R and 180G may be disposed on the first to third wavelength conversion portions 160R to 160B in the second and third sub-pixels SP2 and SP3. The first and second color filters 180R and 180G may increase color purity of light emitted through the first wavelength conversion portion 160R and the second wavelength conversion portion 160G. In some example embodiments, a third color filter may also be disposed on the third wavelength conversion portion 160B.

The planarization layer 184 may be disposed to cover upper surfaces of the first and second color filters 180R and 180G and the sealing layer 182. The planarization layer 184 may be a transparent layer. Additionally, the microlenses 185 may be disposed to correspond to the first to third wavelength conversion portions 160R to 160B on the planarization layer 184, respectively. The microlenses 185 may collect light incident from the first to third wavelength conversion portions 160R to 160B. The microlenses 185 may have a diameter larger than widths of the LED cells LC in the X-direction and Y-direction, for example. The microlenses 185 may be formed of, for example, a transparent photoresist material, a transparent thermosetting resin film, or the like.

FIGS. 13A to 13D are cross-sectional diagrams illustrating a portion of processes of a method of manufacturing a display apparatus, according to an example embodiment.

Referring to FIG. 13A, an under-semiconductor layer 111 and a first conductivity-type semiconductor base layer 112B may be formed in order on a growth substrate 101, and a plurality of LED cells LC1 to LC3 may be formed by forming a first conductivity-type semiconductor layer 112, first to third active layers 114R to 114B, and second conductivity-type semiconductor layer 116 in order on the first conductivity-type semiconductor base layer 112B. The plurality of LED cells LC1 to LC3 may include first to third active layers 114R to 114B configured to emit light of different wavelengths (e.g., colors), respectively. A contact electrode 152 may be formed on the second conductivity-type semiconductor layer 116.

The growth substrate 101 may be formed for nitride single crystal growth and may include, for example, at least one of sapphire (Al₂O₃), silicon (Si), silicon carbide (SiC), magnesium aluminate (MgAl₂O₄), magnesium oxide (MgO), lithium aluminate (LiAlO₂), lithium gallium oxide (LiGaO₂), gallium nitride (GaN), or the like. The under-semiconductor layer 111, the first conductivity-type semiconductor base layer 112B, the first to third active layers 114R to 114B, and the second conductivity-type semiconductor layer 116 may be formed using, for example, metal organic chemical vapor deposition (MOCVD), hydrogenated vapor phase epitaxy (HVPE), molecular beam epitaxy (MBE) processes, or the like.

In some example embodiments, the under-semiconductor layer 111 may include a buffer layer and an undoped nitride layer (e.g., gallium nitride (GaN)). The buffer layer may be formed for alleviating lattice defects of the first conductivity-type semiconductor layer 112 and may include an undoped nitride semiconductor such as, but not limited to, undoped gallium nitride (GaN), undoped aluminum nitride (AlN), and undoped indium gallium nitride (InₓGa₁₋ₓN). The first conductivity-type semiconductor base layer 112B and the first conductivity-type semiconductor layer 112 may be N-type nitride semiconductor layers such as, but not limited to, N-type gallium nitride (GaN). The first conductivity-type semiconductor base layer 112B may include high-concentration N-type gallium nitride (GaN) providing a contact region. The second conductivity-type semiconductor layer 116 may be a P-type nitride semiconductor layer such as, but not limited to, P-type gallium nitride (GaN)/P-type AlGaN. Each of the first to third active layers 114R to 114B may be a single quantum well or multiple quantum well structure such as, but not limited to, indium gallium nitride (InₓGa₁₋ₓN)/gallium nitride (GaN). The contact electrode 152 may include a transparent electrode or a highly reflective ohmic contact layer.

In the present process, a stack structure of the first conductivity-type semiconductor layer 112, the active layer 114, the second conductivity-type semiconductor layer 116, and the contact layer may be dry-etched and may form LED cells LC1 to LC3. In the dry etching process, the LED cells LC1 to LC3 may have damage regions DR in which crystal defects may occur.

Thereafter, referring to FIG. 13B, the damage regions DR may be removed from the LED cells LC1 to LC3 and spacers 160 covering the LED cells from which the damage regions DR are removed may be formed.

The damage regions DR may be selectively removed, for example, by wet etching. Accordingly, non-radiative recombination by the damage regions DR may be reduced, thereby potentially improving brightness.

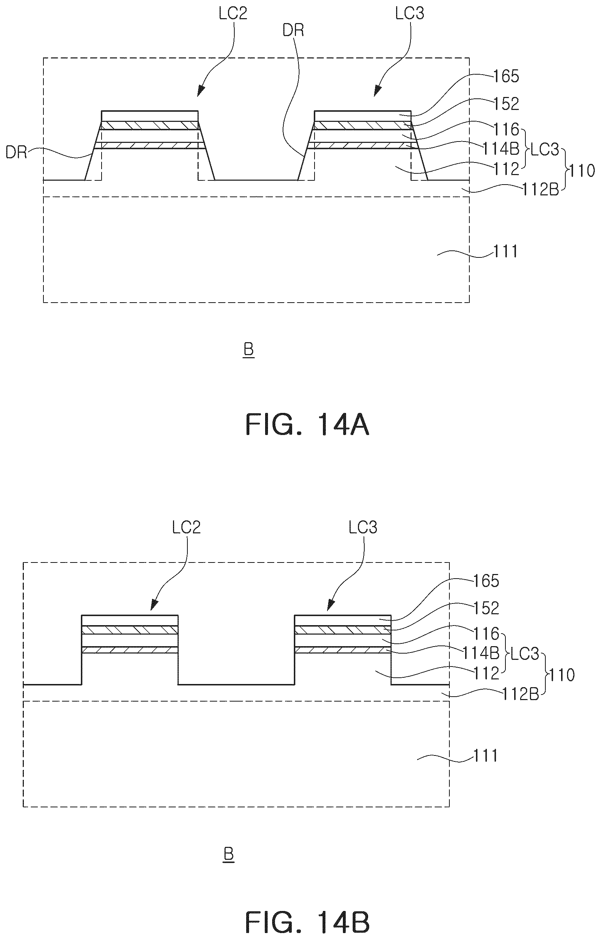

A plurality of spacers 160 may be formed from surrounding side surfaces and upper surfaces of the LED cells LC1 to LC3. The spacers 160 may have an inclined sidewall 160S. The process of forming the spacers 160 employed in the example embodiment is described with reference to FIGS. 14A to 14F.

Referring to FIG. 14A, a mask 165 may be formed on the LED cells LC1 to LC3 as illustrated in FIG. 13A. The mask 165 may be formed on the contact electrode 152. For example, the mask 165 may include, but is not limited to, silicon oxide (SiO₂), silicon oxycarbide (SiOC), silicon oxynitride (SiOₓN_{y}), silicon carbonate nitride (SiOₓC_{y}N_{z}), or the like.

Referring to FIG. 14B, the damage region DR may be removed by applying the above-described wet etching using the mask 165. For example, wet etching may use a potassium hydroxide (KOH), a tetramethylammonium hydroxide (TMAH) solution, or the like. After the damage region DR is removed, cross-sections of the LED cells LC1 to LC3 may be changed from a trapezoidal shape to a rectangular shape. In the wet etching process, the damage regions DR may be removed, and side surfaces of the LED cells LC1 to LC3 may have stable crystal planes. For example, the LED cells LC1 to LC3 may have vertical and/or substantially vertical side surfaces.

Referring to FIG. 14C, a first spacer material layer 161' may be deposited on the LED cells LC1 to LC3 on which the mask 165 is formed. The first spacer material layer 161' may be formed to cover upper surfaces and side surfaces of the LED cells LC1 to LC3, and may also be formed on an upper surface of the first conductivity-type semiconductor base layer 112B.

Thereafter, referring to FIG. 14D, anisotropic etching may be applied to the first spacer material layer 161'. For example, by applying an etch-back to the first spacer material layer 161', a first spacer 161 having rounded corners of the upper surfaces of the LED cells LC1 to LC3 may be formed. By performing the etch-back process until the portion of the first spacer material layer 161' disposed on the upper surface of the first conductivity-type semiconductor base layer 112B is removed, the first spacer 161 may have a first sidewall of which an upper region has a relatively inclined curved surface.

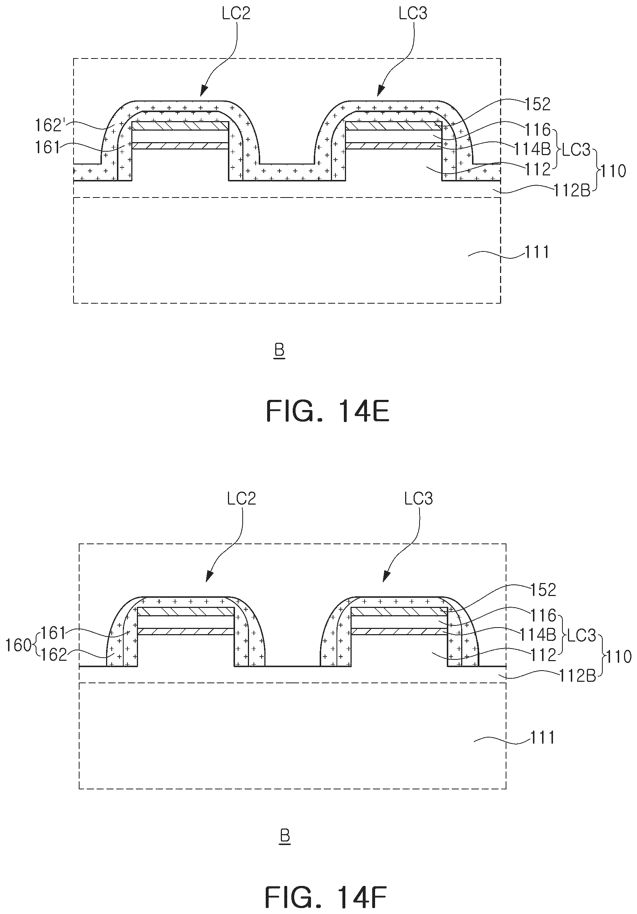

Thereafter, referring to FIG. 14E, a second spacer material layer 162' may be deposited on the LED cells LC1, LC2, and LC3 on which the first spacer 161 is formed, similarly to the process in FIG. 14D. The second spacer material layer 162' may be formed to cover upper surfaces and side surfaces of the LED cells LC1 to LC3, and may also be formed on an upper surface of the first conductivity-type semiconductor base layer 112B. Since the second spacer material layer 162' is disposed on the inclined first sidewall of the first spacer 161, the second spacer material layer 162' may also have an inclined sidewall.

Thereafter, referring to FIG. 14F, a second etch-back process may be applied to the second spacer material layer 162' similarly to the process in FIG. 14D. For example, by performing the second etch-back process until a portion of the second spacer material layer 162' disposed on the upper surface of the first conductivity-type semiconductor base layer 112B is removed, the second spacer 162 may have a second sidewall which is more inclined than the first sidewall. Accordingly, the final spacer 160 may have a sufficiently inclined sidewall provided by the second sidewall. Through this process, the sidewall of the spacer 160 may have an inclined sidewall of 50% or more (e.g., 80% or more) of the entire height thereof.

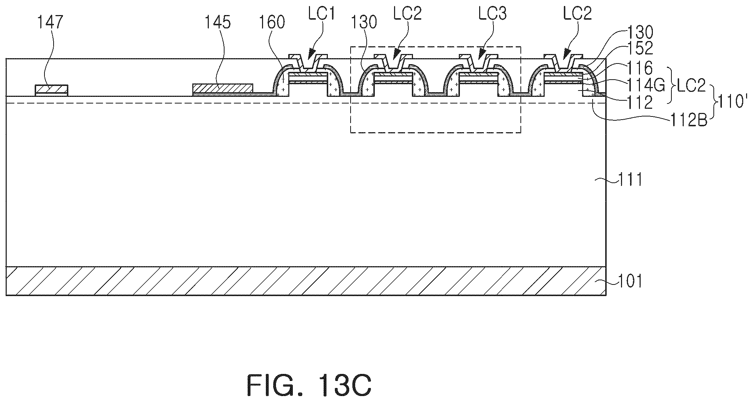

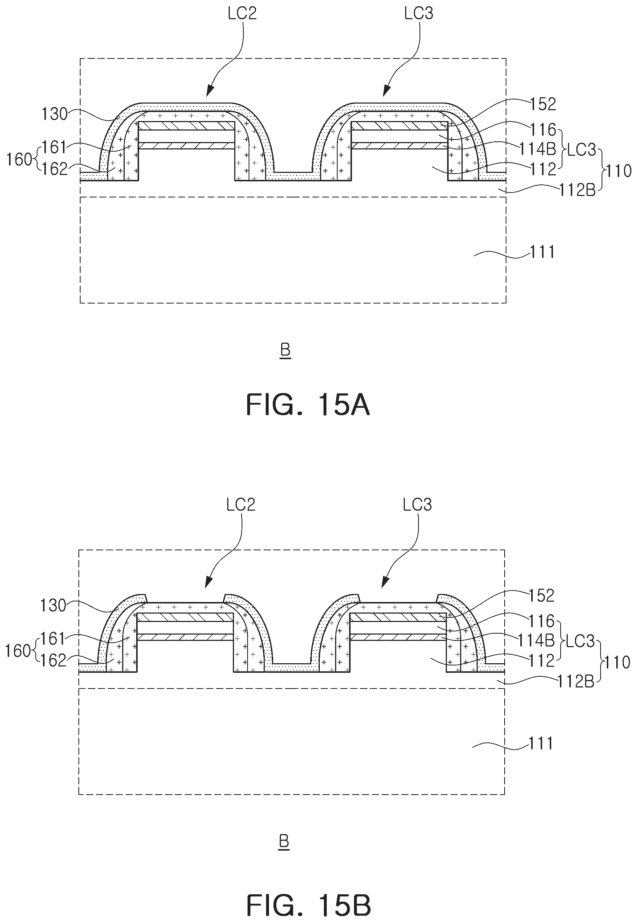

Referring to FIG. 13C, a reflective electrode 130 may be formed on each of the LED cells, and a common electrode 145 and a pad electrode 147 may be formed on a peripheral region of the semiconductor stack 110. Thereafter, a gap-fill insulating layer 141 may be formed, and connection electrodes 155 connected to the contact electrodes 152 may be formed. The process may be described with reference to FIGS. 15A to 15E.

First, the reflective electrode 130 may be formed on the spacers 160 and regions of the first conductivity-type semiconductor base layer 112B between the spacers 160, as described with reference to FIG. 15A. The reflective electrode 130 may have a reflective portion 130R of a bowl shape depending on an inclined sidewall of the spacer 160. The reflective electrode 130 may be electrically connected to the region of the first conductivity-type semiconductor base layer 112B between the plurality of LED cells LC1 to LC3. Thereafter, a common electrode 145 and a pad electrode 147 may be formed on the connection region CR and the pad regions PAD, respectively. The common electrode 145 may be connected to the first conductivity-type semiconductor base layer 112B. The common electrode 145 may be formed on the extension portion 130E of the reflective electrode 130. The common electrode 145 and the pad electrode 147 may be formed together through the same process.

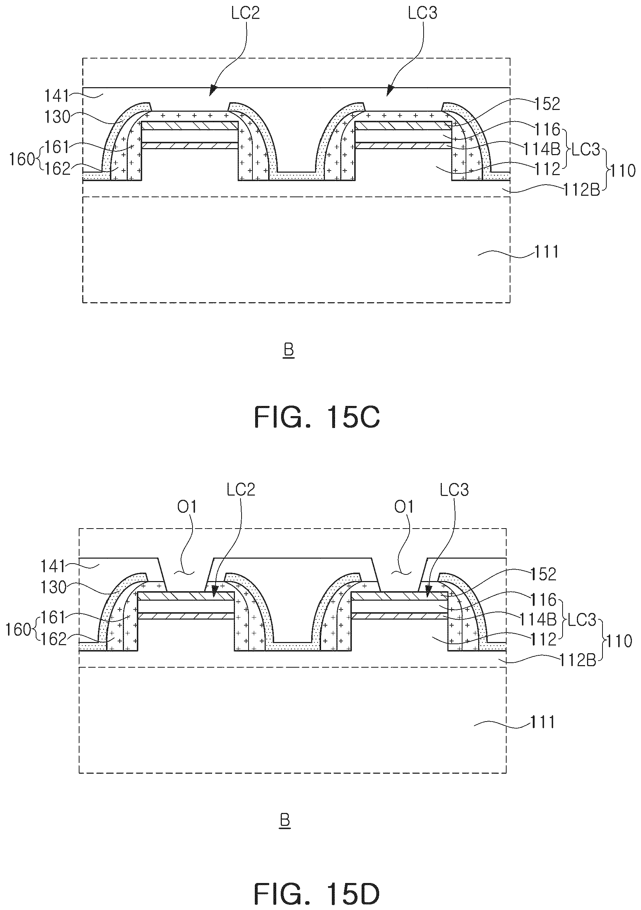

Thereafter, a portion of the reflective electrode 130 disposed in an upper portion of the plurality of LED cells LC1 to LC3 may be removed, as shown in FIG. 15B. The regions from which the reflective electrode is partially removed may be provided as a path on which a second electrode structure is formed. Thereafter, the gap-fill insulating layer 141 may be formed to cover the upper surface of the semiconductor stack 110 on which the reflective electrode 130 is formed, and a process of planarizing the gap-fill insulating layer 141 using a chemical mechanical polishing (CMP) process or an etch-back process may be performed, as described with reference to FIG. 15C. For example, the gap-fill insulating layer 141 may be a low-κ dielectric such as, but not limited to, silicon oxide (SiO₂).

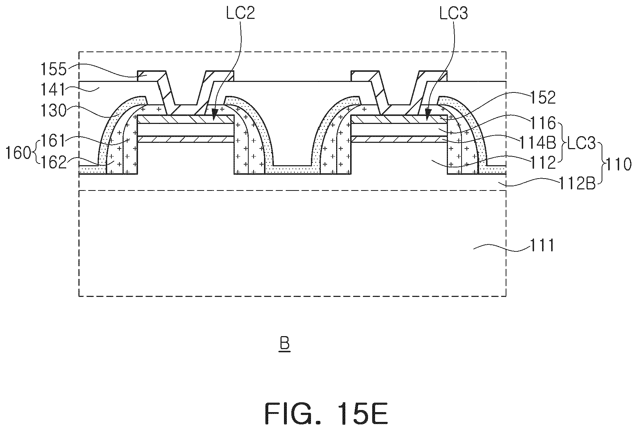

Thereafter, contact holes O1 for opening the contact electrodes 152 by penetrating the gap-fill insulating layer 141 may be formed (as shown in FIG. 15D), and connection electrodes 155 may be formed on the gap-fill insulating layer 141 such that the contact holes O1 may be filled with a conductive material (as shown in FIG. 15E). The connection electrodes 155 may be connected to the contact electrodes 152, respectively, through the contact holes O1.

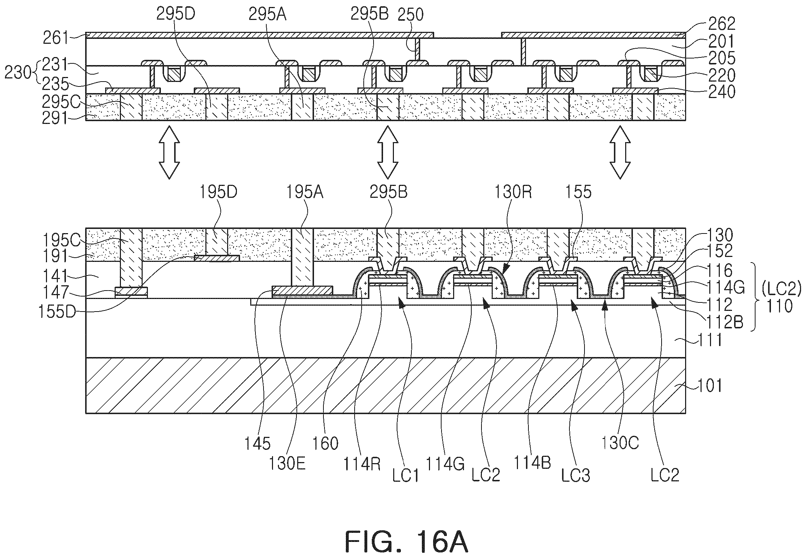

FIGS. 16A to 16C are cross-sectional diagrams illustrating the other portion of processes of a method of manufacturing a display apparatus, according to an example embodiment.

Referring to FIG. 16A, a pixel array structure including first to third LED cells LC1 to LC3 may be bonded to a circuit board 200.

The circuit board 200 may be prepared through a separate process. The pixel array 100' and the circuit board 200 may be bonded to each other at a wafer level by a wafer bonding method, for example, the hybrid bonding described above. The circuit board 200 may include a lower bonding structure 290 having a lower bonding insulating layer 291 and lower bonding electrodes 295, as described above. The lower bonding electrodes 295 may be bonded to the upper bonding electrodes 195, and the lower bonding insulating layer 291 may be bonded to the upper bonding insulating layer 191. As described above, the pixel array 100' including the LED cells LC1 to LC3 and the circuit board 200 may be bonded to each other without an adhesive layer.

Referring to FIG. 16B, the growth substrate 101 may be removed, and a portion of the semiconductor stack 110, that is, the under-semiconductor layer 111, may be removed.

The growth substrate 101 may be removed by various processes, such as, but not limited to, laser lift-off, mechanical polishing or mechanical chemical polishing, and an etching process. The under-semiconductor layer 111 may be partially removed to a predetermined thickness, for example, using a polishing process, such as CMP. After the under-semiconductor layer 111 is removed, the first conductivity-type semiconductor base layer 112B may be exposed.

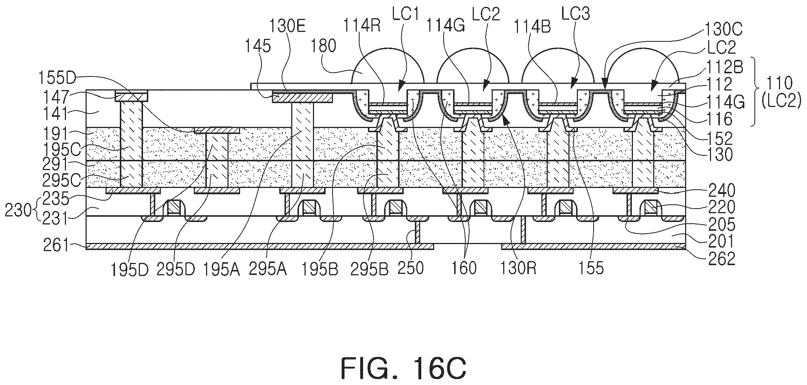

Referring to FIG. 16C, the first conductivity-type semiconductor base layer 112B disposed in the pad region PAD may be further removed, and microlenses 180 and bonding pads (e.g., bonding pad 199 of FIG. 3) may be further formed, thereby manufacturing the display apparatus 10 illustrated in FIGS. 3 and 4.

FIGS. 17A to 17C are cross-sectional diagrams illustrating a portion of processes of a method of manufacturing a display apparatus, according to an example embodiment. The process may be a formation process for a reflective structure included in the display apparatus 10A illustrated in FIGS. 6 and 7.

Referring to FIG. 17A, the first conductivity-type semiconductor base layer 112B may be further etched using the spacer 160 as a mask, thereby forming a recess R. In the example embodiment, the spacer 160 may be a structure obtained through the processes described with reference to FIGS. 14A to 14F. The first conductivity-type semiconductor base layer 112B region provided to a bottom of the recess R may be provided as a contact region. Since a depth to the contact region may be further etched through the recess process, the LED cells LC1 to LC3 may be formed to have a relatively small height. For example, the aspect ratio of the LED cells LC1 to LC3 may be one (1) or less.

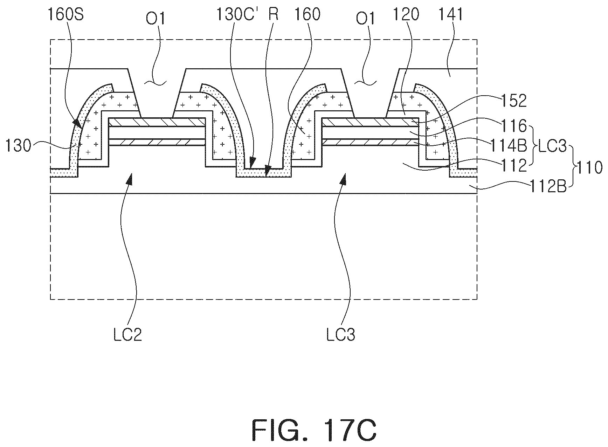

Referring to FIG. 17B, the reflective electrode 130' may be formed to be connected to the bottom of the recess R along a sidewall of the spacer 160. Referring to FIG. 17C, a portion of the reflective electrode 130 disposed on the plurality of LED cells LC1 to LC3 may be removed, and a gap-fill insulating layer 141 may be formed to cover an upper surface of the semiconductor stack 110 on which the reflective electrode 130 is formed. Thereafter, contact holes O1 penetrating the gap-fill insulating layer 141 and opening the contact electrodes 152, respectively, may be formed. Thereafter, similarly to the subsequent processes in the aforementioned example embodiments (e.g., as described with reference to FIG. 15E), the connection electrodes 155 may be formed on the gap-fill insulating layer 141 such that the contact holes O1 may be filled with a conductive material.

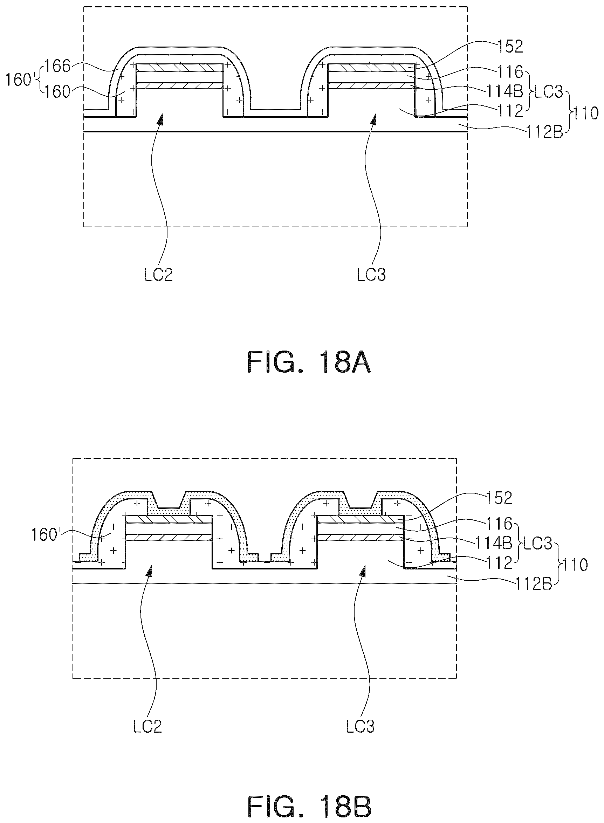

FIGS. 18A to 18D are cross-sectional diagrams illustrating a portion of processes of a method of manufacturing a display apparatus, according to an example embodiment. The process may be the formation process for a reflective structure included into the display apparatus 10C illustrated in FIGS. 9 and 10.

Referring to FIG. 18A, an additional spacer material layer 166 may be deposited on the spacers 160 covering the LED cells LC1 to LC3. The additional spacer material layer 166 may be formed to cover a surface of the first conductivity-type semiconductor base layer 112B exposed between the spacers 160. The spacers 160 covering the LED cells LC1 to LC3 before this process may be understood as a structure obtained by the serial processes described with reference to FIGS. 14A to 14F.

Referring to FIG. 18B, a first contact hole O1 for opening a contact electrode 152 may be formed in a new spacer 160' obtained by a previous process, a reflective electrode layer connected to the contact electrode 152 through the first contact hole O1 may be formed, and the reflective electrodes 130' may be isolated from each other by unit of LED cell. In the example embodiment, the spacer 160' may extend and may be connected to each other in a region between the plurality of LED cells LC1 to LC3, and the reflective electrodes 130' and the first conductivity-type semiconductor base layer 112B may be electrically isolated from each other by the extended portion of the spacer 160'.

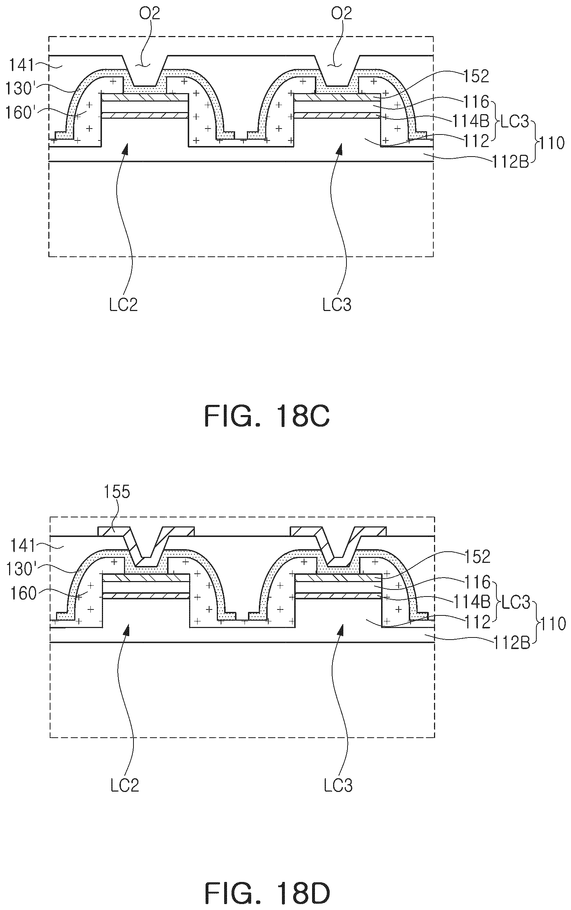

Referring to FIG. 18C, a gap-fill insulating layer 141 may be formed to cover the reflective electrode 130', and second contact holes O2 penetrating the gap-fill insulating layer 141 and opening the reflective electrodes 130', respectively, may be formed. Referring to FIG. 18D, connection electrodes 155 may be formed on the gap-fill insulating layer 141 such that the second contact holes O2 may be filled with a conductive material.

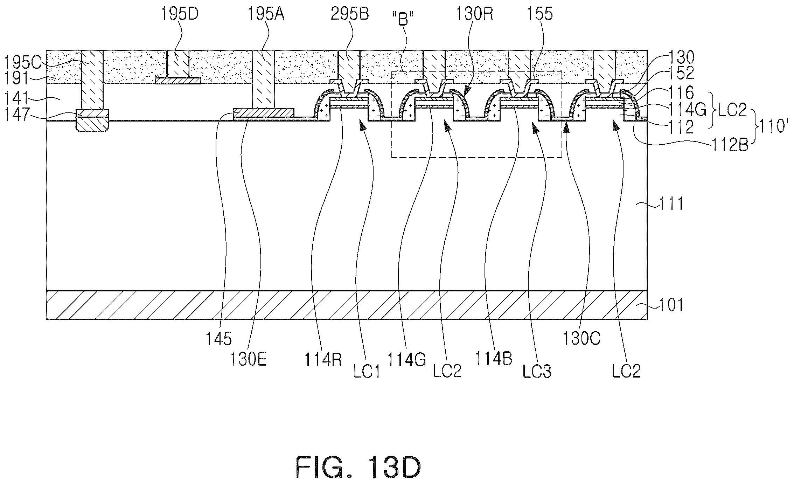

By performing a process similar to the subsequent process in FIG. 13D (forming a bonding structure) and the process (bonding between a circuit board) in FIG. 16A to FIG. 16C, the display apparatus 10C illustrated in FIG. 10 and FIG. 11 may be formed. However, in the process in FIG. 16B, a process of isolating the plurality of LED cells LC1 to LC3 by further etching the first conductivity-type semiconductor base layer 112B and a process of forming the first electrode 135 connected to the upper surface of the plurality of LED cells LC1 to LC3 and a connection structure thereof may be further performed.

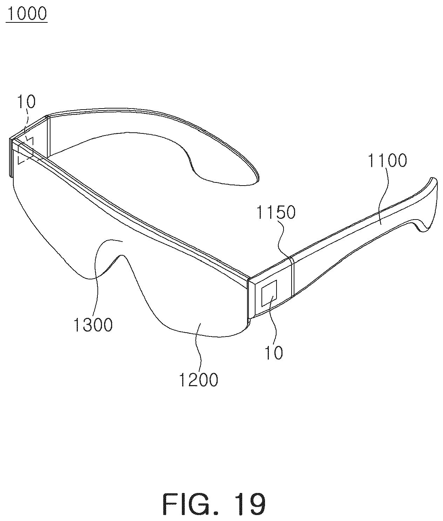

FIG. 19 is a diagram illustrating an electronic device including a display apparatus, according to an example embodiment.

Referring to FIG. 19, an electronic device 1000, according to the example embodiment, may be and/or may include a wearable device, such as, but not limited to, a glasses-type display. The electronic device 1000 may include a pair of temples 1100, a pair of optical coupling lenses 1200, and a bridge 1300. The electronic device 1000 may further include a display apparatus 10 including an image generation portion.

The electronic device 1000 may be and/or may include a head-mounted, glasses-type, or goggle-type virtual reality (VR) device, augmented reality (AR) device, or a mixed reality (MR) device that may provide a virtual reality and/or may provide a virtual image and an external real landscape together.

The temples 1100 may extend in one direction. The temples 1100 may be spaced apart from each other and may extend in parallel. The temples 1100 may be folded toward the bridge 1300 using a hinge connection portion 1150. The bridge 1300 may be provided between the optical coupling lenses 1200 and may connect the optical coupling lenses 1200 to each other. The optical coupling lenses 1200 may include a light guide plate. The display apparatus 10 may be disposed in a portion of the temples 1100 adjacent to the optical coupling lenses 1200, and may generate an image in the optical coupling lenses 1200. In some example embodiments, the display apparatus 10 may be disposed in a region of the optical coupling lenses 1200.

According to the aforementioned example embodiments, by including an inclined spacer to each of the micro-sized LED cells employed as a light source of the display, a reflective structure having a shape similar to a bowl may be formed. The reflective structures may capture light by controlling a beam angle of each LED cell and may increase light efficiency in a desired region, when compared to a related LED cell.

While aspects of the example embodiments have been illustrated and described above, it is to be apparent to those skilled in the art that modifications and variations may be made without departing from the scope of the present disclosure as defined by the appended claims.

## Claims

1. A display apparatus, comprising a pixel array (100; 100') which comprises:
a plurality of pixel units (PX), each of the plurality of pixel units (PX) comprising a plurality of sub-pixels (SP1, SP2, SP3),
a semiconductor stack (110) comprising:
a first conductivity-type semiconductor base layer (112b) having an upper surface provided as a light emitting surface;
a plurality of light-emitting diode, LED, cells (LC1, LC2, LC3) on a lower surface of the first conductivity-type semiconductor base layer (112b), each of the plurality of LED cells (LC1, LC2, LC3) comprising at least an active layer (114R, 114G, 114B); and
a second conductivity-type semiconductor layer (116) stacked on the lower surface of the first conductivity-type semiconductor base layer (112b);
a spacer (160; 160') at least partially covering a side surface and a lower surface of each of the plurality of LED cells (LC1, LC2, LC3) and having an inclined sidewall (160S), the spacer (160; 160') comprising a contact hole coupled with a second portion of the second conductivity-type semiconductor layer (116) on the lower surface of each of the plurality of LED cells (LC1, LC2, LC3);
a reflective electrode (130; 130') disposed on the inclined sidewall (160S) of the spacer (160; 160') and electrically coupled with a first portion of the first conductivity-type semiconductor base layer (112b) between the plurality of LED cells (LC1, LC2, LC3); and
a plurality of connection electrodes (155) electrically coupled with the second portion of the second conductivity-type semiconductor layer (116) on the lower surface of each of the plurality of LED cells (LC1, LC2, LC3) through the contact hole.

2. The display apparatus of claim 1, wherein each of the plurality of LED cells (LC1, LC2, LC3) further comprises a transparent electrode (152) on a lower surface of the second conductivity-type semiconductor layer (116).

3. The display apparatus of claim 1 or 2, wherein the inclined sidewall (160S) of the spacer (160; 160') comprises an inclined portion extending from a third portion at least partially covering the lower surface of each of the plurality of LED cells (LC1, LC2, LC3) to a fourth portion having a level higher than a level of the active layer (114R, 114G, 114B).

4. The display apparatus of claim 1 or 2, wherein the inclined sidewall (160S) of the spacer (160; 160') comprises an inclined portion extending from a third portion at least partially covering the lower surface of each of the plurality of LED cells (LC1, LC2, LC3) to a fourth portion having a height of at least 50% of a height of the inclined sidewall (160S).

5. The display apparatus of any one of claims 1 to 4, wherein the spacer (160) comprises:
a first spacer (161) at least partially surrounding the side surface and the lower surface of each of the plurality of LED cells (LC1, LC2, LC3) and having a first inclined sidewall; and
a second spacer (162) disposed on the first spacer (161) and having a second inclined sidewall.

6. The display apparatus of any one of claims 1 to 5, wherein the reflective electrode (130; 130') comprises at least one of silver, Ag, chromium, Cr, nickel, Ni, titanium, Ti, aluminum, Al, rhodium, Rh, ruthenium, Ru, or combinations thereof.

7. The display apparatus of any one of claims 1 to 6, further comprising:
a passivation layer (120) at least partially covering the side surface and the lower surface of each of the plurality of LED cells (LC1, LC2, LC3) on the spacer (160; 160').

8. The display apparatus of claim 7, wherein the passivation layer (120) comprises at least one of zirconium oxide, ZrO₂, aluminum oxide, Al₂O₃, or hafnium oxide, HfO₂.

9. The display apparatus of any one of claims 1 to 8, further comprising:
an etching stop layer (170) disposed on the spacer (160), a fifth portion of the first conductivity-type semiconductor base layer (112b), and the side surface and the lower surface of each of the plurality of LED cells (LC1, LC2, LC3).

10. The display apparatus of claim 9, wherein the etching stop layer (170) comprises at least one of silicon nitride, Si₃N₄, silicon oxynitride, SiOₓN_{y}, aluminum oxide, Al₂O₃, aluminum oxynitride, AlON, or aluminum nitride, AlN.

11. The display apparatus of any one of claims 1 to 10, wherein a thickness of the first conductivity-type semiconductor base layer (112b) has a range of 0.1 µm to 2 µm.

12. The display apparatus of any one of claims 1 to 11, wherein the first conductivity-type semiconductor base layer (112b) comprises a recess (R) in a region between the plurality of LED cells (LC1, LC2, LC3), and
wherein the reflective electrode (130; 130') is electrically coupled with a bottom of the recess (R).

13. The display apparatus of any one of claims 1 to 12, wherein an aspect ratio of each of the plurality of LED cells (LC1, LC2, LC3) is less than or equal to one.

14. The display apparatus of any one of claims 1 to 13, wherein the pixel array (100; 100') further comprises a gap-fill insulating layer (141) disposed on a lower surface of the semiconductor stack (110) and at least partially covering the reflective electrode (130; 130'),
wherein the contact hole extends into the gap-fill insulating layer (141), and
wherein each of the plurality of connection electrodes (155) is electrically coupled with the second portion of the second conductivity-type semiconductor layer (116) through the contact hole.

15. The display apparatus of any one of claims 1 to 14, further comprising:
a circuit board (200) on a lower surface of the pixel array (100; 100') and comprising a driving circuit,
wherein the reflective electrode (130; 130') is provided as a common electrode of the plurality of LED cells (LC1, LC2, LC3), and
wherein each of the plurality of connection electrodes (155) is provided as an individual electrode for individually driving the plurality of LED cells (LC1, LC2, LC3).
